(19) Europäisches Patentamt
European Patent Office
Office européen des brevets

(11) **EP 3 213 356 B1**

(12) **EUROPEAN PATENT SPECIFICATION**

(45) Date of publication and mention
of the grant of the patent:
**06.01.2021 Bulletin 2021/01**

(51) Int Cl.:
*H01L 39/12* (2006.01)        *H01L 39/00* (2006.01)
*H01L 39/24* (2006.01)        *C04B 35/45* (2006.01)
*C04B 35/626* (2006.01)

(21) Application number: **15790686.8**

(22) Date of filing: **27.10.2015**

(86) International application number:
**PCT/IB2015/058288**

(87) International publication number:
**WO 2016/067205 (06.05.2016 Gazette 2016/18)**

(54) **HIGH TEMPERATURE SUPERCONDUCTORS**

HOCHTEMPERATUR-SUPRALEITER

SUPRACONDUCTEURS À HAUTE TEMPÉRATURE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.10.2014 US 201462069212 P**

(43) Date of publication of application:
**06.09.2017 Bulletin 2017/36**

(73) Proprietor: **Quantum Designed Materials Ltd.
7670204 Rehovot (IL)**

(72) Inventor: **GATT, Refael
76804 Mazkeret Batya (IL)**

(74) Representative: **Fish & Richardson P.C.
Highlight Business Towers
Mies-van-der-Rohe-Straße 8
80807 München (DE)**

(56) References cited:
**US-A- 5 756 427     US-A1- 2002 098 986**

• KAWAI T ET AL: "Effect of alkaline metal
substitutions to Bi-Sr-Ca-Cu-O superconductor",
PHYSICA C, NORTH-HOLLAND PUBLISHING,
AMSTERDAM, NL, vol. 161, no. 5-6, 15 December
1989 (1989-12-15), pages 561-566, XP024468223,
ISSN: 0921-4534, DOI:
10.1016/0921-4534(89)90390-0 [retrieved on
1989-12-15]

• L. D. SÝKOROVÁ ET AL: "Effect of doping on
properties of Bi-based superconductors",
PHYSICA STATUS SOLIDI (C), vol. 1, no. 7, 1 May
2004 (2004-05-01), pages 1952-1956,
XP055242463, DE ISSN: 1610-1634, DOI:
10.1002/pssc.200304466

• ZHIGADLO N D ET AL: "The effects of Cs doping,
heat treatments on the phase formation and
superconducting properties of
(Bi,Pb)-Sr-Ca-Cu-O ceramics", PHYSICA C,
NORTH-HOLLAND PUBLISHING, AMSTERDAM,
NL, vol. 299, no. 3-4, 1 April 1998 (1998-04-01),
pages 327-337, XP004149056, ISSN: 0921-4534,
DOI: 10.1016/S0921-4534(97)01866-2

• ÖZÇELIK B ET AL: "Effect of K substitution on
Structural, Electrical and Magnetic Properties of
Bi-2212 system", JOURNAL OF MATERIALS
SCIENCE. MATERIALS IN ELECTRONICS,
CHAPMAN AND HALL, LONDON, GB, vol. 25, no.
10, 29 July 2014 (2014-07-29) , pages 4476-4482,
XP035390302, ISSN: 0957-4522, DOI:
10.1007/S10854-014-2190-X [retrieved on
2014-07-29]

• DOU S-X ET AL: "Mechanism of the Tc
enhancement in Bi2Sr2CaCu2O8+y by sodium
doping", PHYSICA C, NORTH-HOLLAND
PUBLISHING, AMSTERDAM, NL, vol. 185-189, 1
December 1991 (1991-12-01) , pages 811-812,
XP024684273, ISSN: 0921-4534, DOI:
10.1016/0921-4534(91)91629-I [retrieved on
1991-12-01]

- K Q Ruan ET AL: "The systematic study of the normal-state transport properties of Bi-2212 crystals Home Search Collections Journals About Contact us My IOPscience The systematic study of the normal-state transport properties of Bi-2212 crystals", J. Phys.: Condens. Matter, 10 May 1999 (1999-05-10), pages 3743-3750, XP055242465, DOI: 10.1088/0953-8984/11/18/309 Retrieved from the Internet: URL:http://iopscience.iop.org/article/10.1 088/0953-8984/11/18/309/pdf [retrieved on 2016-01-18]
- STIUFIUC G ET AL: "Anomalous normal state properties of underdoped Bi 2212 thin films", INTERNATIONAL JOURNAL OF MODERN PHYSICS B, WORLD SCIENTIFIC, SINGAPORE, SG, vol. 18, no. 15, 20 June 2004 (2004-06-20) , pages 2209-2214, XP009187921, ISSN: 0217-9792
- BOULESTEIX C ET AL: "Conductivity of layered superconducting crystals in the normal state: case of Bi2+xSr2Ca1-yCu2O8+[delta] - importance of the oxygen and cationic concentrations, role of superconductive fluctuations above Tc", KEY ENGINEERING MATERIALS, TRANS TECH PUBLICATIONS LTD., STAFA-ZURICH, CH, vol. 155-156, 1 January 1998 (1998-01-01), pages 413-428, XP009187920, ISSN: 1013-9826
- Y Zhao ET AL: "Normal-state reentrant behavior in superconducting Bi2Sr2CaCu2O8/Bi2Sr2Ca2Cu3O10 intergrowth single crystals", PHYSICAL REVIEW B, vol. 51, no. 5 1 February 1995 (1995-02-01), XP055242467, ISSN: 1098-0121, DOI: 10.1103/PhysRevB.51.3134 Retrieved from the Internet: URL:http://journals.aps.org/prb/pdf/10.110 3/PhysRevB.51.3134 [retrieved on 2016-01-18]
- CHRISTIAN E PRECKER ET AL: "Identification of a possible superconducting transition above room temperature in natural graphite crystals", ARXIV.ORG, CORNELL UNIVERSITY LIBRARY, 201 OLIN LIBRARY CORNELL UNIVERSITY ITHACA, NY 14853, 30 June 2016 (2016-06-30), XP080966341, DOI: 10.1088/1367-2630/18/11/113041

**Description**

**TECHNICAL FIELD**

The present invention relates to manufacturing metal oxides and the resulting oxides. These oxides exhibit specific and reproducible characteristics of the resistivity as a function of temperature at high temperatures. This characteristic is interpreted as high temperature superconductivity.

**BACKGROUND**

In 1986, Bednorz and Muller surprised the solid state physics community with their announcement of a new class of superconducting materials having critical temperatures (Tc) significantly higher than those achieved previously [Bednorz, et al., Z. Phys. B 64, 189 (1986)]. These materials are ceramics consisting of copper oxide layers separated by buffer cations. In Bednorz and Muller's original compound (LBCO), the buffer cations are lanthanum and barium. Inspired by their work and motivated by his own critical temperature under pressure measurements, Paul Chu synthesized a similar material in which the buffer ions were yttrium and barium. This material was YBCO, the first superconductor with a Tc above the boiling point of liquid nitrogen (77K) [Wu, et al., Phys. Rev. Lett. 58, 908 (1987)]. The highest critical temperature reported to date is 164K, obtained by a mercury based superconductor at a pressure of 31 GPa. [Putilin, et al., Nature 362, 226 (1993), and Chu, et al., Nature 365, 323 (1993)].

Kawai, T. et al., describe in Physica C, vol. 161 (1989) on pages 561-566, the effect of alkaline metal substitutions to Bi-Sr-Ca-Cu-O superconductors.

Sykorova, LD et al. describe in Phys. Stat. Sol., vol. 1 (2004), on pages 1952-1956, the effect of doping on properties of Bi-based superconductors.

**SUMMARY**

The present invention is defined by the independent claims. The dependent claims depict other embodiments of the invention.

The manufacturing method of the present invention overcomes a limitation in substitution by alkali metals in manufacturing due to evaporation during sintering. Furthermore, this disclosure is based on the unexpected discovery that the resulting metal oxides containing alkali metal ions in their crystal structures exhibit specific characteristics of the resistivity as a function of temperature which is interpreted such that they are superconductors at extremely high temperatures (e.g., up to about 550K).

In one aspect, this disclosure features a compound of formula (I):

$$L_n D_m (B_x B'_{1-x})_r (Z_t Z'_{1-t})_q M_p A_y \qquad (I),$$

in which n is a number from 0 to 3; m is a number from 0 to 6, x is a number from 0.4 to 1; r is a number from 1 to 8; t is a number from 0 to 1; q is a number from 0 to 6; p is a number from 1 to 7; y is a number from 1 to 20; L includes Bi, Cu, or Hg; D includes at least one element selected from the group consisting of the elements in Groups IIIA and IVA in the Periodic Table; B includes at least one first alkali metal ion selected from the group consisting of Na, K, Rb, and Cs; B' includes at least one first ion selected from the group consisting of alkaline earth metal ions and rare earth metal ions; Z includes at least one second alkali metal ion selected from the group consisting of Na, K, Rb, and Cs; Z' includes at least one second ion selected from the group consisting of alkaline earth metal ions and rare earth metal ions; M includes at least one transition metal ion; and A is O. The compound of formula (I) is a crystalline compound. In some embodiments, D includes C, Si, Ge, Sn, Pb, or Al. In some embodiments, B' includes La, Mg, Ca, Sr, or Ba. In some embodiments, Z' includes Ca or Y. In some embodiments, M includes Cu or Fe. In some embodiments, the compound has a tetragonal or orthorhombic crystal structure. In some embodiments, the compound is $Bi_2 Rb_2 Sr_2 CaCu_2 O_y$.

In another aspect, this disclosure features a compound, which is a crystalline metal oxide containing at least one transition metal ion inlcuding Bi, Cu, or Hg and at least one alkaline earth metal ion (e.g., Sr or Ca) or at least one rare earth metal ion in which from 50% to 95% of the at least one alkaline earth metal ion or at least one rare earth metal ion is replaced by an alkali metal ion including Na, K, Rb, or Cs. In some embodiments, the crystalline metal oxide before modification is $Bi_2 Sr_2 CaCu_2 O_y$.

In another aspect, this disclosure features a method that includes (1) mixing a crystalline metal oxide with an alkali metal salt containing an alkali metal ion to form a mixture, in which the metal oxide contain at least one transition metal ion and at least one alkaline earth metal ion and the atomic ratio between the alkali metal ion and the at least one alkaline earth metal ion is higher than 1:1; and (2) sintering the mixture at an elevated temperature to form a crystalline compound containing the alkali metal ion. In some embodiments, the crystalline metal oxide is $Bi_2 Sr_2 CaCu_2 O_y$. In some

embodiments, from 50% to 95% of the at least one alkaline earth metal ion is replaced by the alkali metal ion. In some embodiments, the atomic ratio between the alkali metal ion and the at least one alkaline earth metal ion is at least 2:1.

In yet another aspect, this disclosure features a composition containing the superconducting compound described herein.

Other features, objects, and advantages will be apparent from the description, drawings, and claims.

**DESCRIPTION OF DRAWINGS**

FIG. 1 is a scheme illustrating an octahedral cluster in the crystal structure of a superconducting compound described herein.

FIG. 2a is a scheme illustrating the relationship among the energy band of a material, its Fermi level and its corresponding conductance according to the Wilson rule and the present disclosure.

FIG. 2b presents the Fermi landscape of a simple metal and a superconductor. Left panel: a simple isotropic 2D metal. The Fermi surface appears as a 1D circle. Right panel: The Fermi landscape of an isotropic 2D superconductor according to the present disclosure. The Fermi volume appears as a 2D ring.

FIG. 2c presents realistic anisotropic Fermi landscape. Left panel: a scheme illustrating measured Fermi landscape of Bi2212 [Norman et. al., Phys. Rev. B, 52, 615 (1995)]. Center panel: a scheme illustrating the Fermi landscape of a possible higher temperature superconductor predicted by the inventor. Right panel: a scheme illustrating the Fermi landscape of a possible even higher temperature superconductor predicted by the inventor.

FIGs. 3a and 3b show known electronic structure results measured by ARPES.

Fig. 4a shows known cluster calculations. The energy difference $2\delta$ is displayed as function of the distance between the buffer ion and the plane. a) The effect of the buffer ion radius on $2\delta$. b) The effect of the buffer ion charge on $2\delta$. c) The effect of the buffer ion softness on $2\delta$.

Fig. 4b presents a table listing the properties of known cuprate superconductors. The critical temperature can be explained by the model described herein. The crystal structure of LBCO and YBCO are given for clarity. Also provided is the factor $\rho_2(q)$ determining the critical temperature and derived from equations (1-8).

FIG. 5 is a graph including a collection of magnetic measurements of Bi2212 and three families of compounds described in Examples 1-6 at room temperature and a field of 1 Tesla.

FIG. 6 is a graph showing the temperature dependence of the resistance of a first HTS sample in the potassium family.

FIG. 7a is a graph showing the magnetic moment as a function of temperature from 50K to 300K for the sample used to obtain the results shown in FIG. 6.

FIG. 7b is a graph showing the magnetic moment as a function of temperature from about 75K to 300K for the sample used to obtain the results shown in FIG. 6.

FIG. 8 shows a SEM micrograph with EDS analysis of the sample used to obtain FIG. 6.

FIG. 9 shows a SEM micrograph with Energy-dispersive X-ray spectroscopy (EDS) analysis of a second HTS sample in the potassium family.

FIG. 10 is a SEM micrograph with EDS analysis obtained at another portion of the same sample used to obtain the results shown in FIG. 9.

FIG. 11 shows the temperature dependent resistance of the sample used to obtain the results shown in FIGs. 9 and 10.

FIG. 12 is a SEM micrograph showing the microstructure of a HTS sample in the rubidium family.

FIG. 13 is a graph showing the temperature dependence of the resistance of the same sample used to obtain the results shown in FIG. 12.

FIG. 14 is a SEM micrograph with EDS analysis of a second sample in the rubidium family.

FIG. 15a shows a SEM micrograph with EDS analysis of a third sample in the rubidium family.

FIG. 15b shows the resistance vs. temperature graph for the sample used to obtain the results shown in FIG. 15a.

FIG. 15c is a graph showing XRD data of the sample used to obtain the results shown in FIG. 15a.

FIG. 16 is a SEM micrograph with EDS analysis of a portion of a sample in the cesium family.

FIG. 17 is a SEM micrograph with EDS analysis at another portion of the same sample used to obtain FIG. 16.

FIG. 18 is a graph showing the temperature dependence of the resistance of the same sample used to obtain FIGs. 16 and 17.

FIG. 19 is a graph showing the magnetic moment as a function of temperature for the same sample used to obtain FIGs. 16 and 17.

FIG. 20 is a screen shot showing XRD data including Rietveld refinement for the same sample used to obtain FIGs. 16 and 17.

Fig. 21 is a SEM micrograph with EDS analysis of a sample in the rubidium family.

Fig. 22a is a SEM micrograph showing a crystallite hanging on a probe in an FEI Helios dual beam system.

Fig. 22b is the spectrum showing the result of the EDS analysis at spot number 14 in Fig. 22a.

Fig. 23 is a graph showing a resistance-temperature curve of a sample grown at the same conditions under which the crystallite shown in Fig. 22a was obtained.

Fig. 24 is a graph showing a magnetic moment-temperature curve of a sample grown at the same conditions under which the crystallite shown in Fig. 22a was obtained.

Fig. 25a is a graph showing the magnetic moment vs. temperature of a sample of the rubidium family grown by the long term ion exchange method.

Fig. 25b is a graph showing the magnetic moment vs. temperature of a sample of the potassium family grown by the long term ion exchange method.

Fig. 26 shows the results of small crystal X-Ray diffraction such as the crystal of Fig. 22a. Left panel: raw data, one of the frames, right panel: atom locations in the crystal.

Fig. 27 shows the various crystal sizes obtained over a period of a year. The graph indicates a significant increase in the crystal size of RTS material.

Like reference symbols in the various drawings indicate like elements.

## DETAILED DESCRIPTION

This disclosure generally relates to manufacturing of metal oxides and the resulting metal oxides which are, compounds exhibiting a behaviour interpreted as superconductivity at a high temperature (e.g., from 273K to 550K).

In some examples, a high temperature superconductor described herein is a compound of formula (I):

$$L_nD_m(B_xB'_{1-x})_r(Z_tZ'_{1-t})_qM_pA_y \qquad (I),$$

in which n is any number from 0 to 3 (e.g., 0, 1, 2, or 3); m is any number from 0 to 6; x is any number from 0.1 to 1; r is any number from 1 to 8 (e.g., 1, 2, 3, 4, 5, 6, 7, or 8); t is any number from 0 to 1; q is any number from 0 to 6 (e.g., 0, 1, 2, 3, 4, 5, or 6); p is any number from 1 to 7 (e.g., 1, 2, 3, 4, 5, 6, or 7); y is any number from 1 to 20; L includes at least one metal ion selected from the group consisting of transition metal ions and post-transition metal ions; D includes at least one element selected from the group consisting of the elements in Groups IIIA (e.g., N, P, As, Sb, or Bi) and IVA (e.g., C, Si, Ge, Sn, or Pb) in the Periodic Table; B includes at least one first alkali metal ion; B' includes at least one first ion selected from the group consisting of alkaline earth metal ions and rare earth metal ions; Z includes at least one second alkali metal ion; Z' includes at least one second ion selected from the group consisting of alkaline earth metal ions and rare earth metal ions; M includes at least one transition metal ion; and A includes at least one anion. The compound of formula (I) is a crystalline compound. In some examples, the compound of formula (I) is a single phase compound. In some examples, the compound of formula (I) is a single crystal compound.

In general, n, m, x, r, t, q, p, and y can be either an integer or a non-integer.

In some examples, the first alkali metal ion is different from the second alkali metal ion. In some examples, the first alkali metal ion is the same as the second alkali metal ion. In some examples, the first ion assigned to B' is different from the second ion assigned to Z'. In some examples, the first ion assigned to B' is the same as the second ion assigned to Z'.

In some examples, the element assigned to D is different from the metal ion assigned to L. In some embodiment, the element assigned to D is the same as the metal ion assigned to L.

The term "alkali metal ion", as used herein, refers to an ion containing an element selected from group IA of the periodic table, i.e., Li, Na, K, Rb, Cs, and Fr or any combination thereof. In general, the alkali metal ion can have a valence number of +1. In some examples, the alkali metal ion can form a molecular cluster having effective electric charge of between +1 and zero. In such examples, the molecular cluster can include one or more negative ions in the proximity of an alkali metal ion such that the positive charge on the alkali metal ion is compensated by the negative charge on the negative ion.

The term "alkaline earth metal ion", as used herein, refers to a metal ion having a valence number of +2 and containing an element selected from group IIA of the periodic table, i.e., Be, Mg, Ca, Sr, Ba, Ra or any combination thereof.

The term "transition metal ion", as used herein, refers to a metal ion containing an element selected from Groups IIIB, IVB, VB, VIB, VIIB, VIIIB, IB and IIB of the Periodic Table. In some examples, the transition metal mentioned herein can be Sc, Ti, V, Cr, Mn, Fe, Ni, Cu, Zn, Y, Zr, Nb, Tc, Ru, Mo, Rh, W, Au, Pt, Pd, Ag, Mn, Co, Cd, Hf, Ta, Re, Os, Ir, Hg, or any combination thereof. In some examples, the transition metal is Cu. In other examples, the transition metal is Fe or Zn.

The term "post-transition metal ion", as used herein, refers to a metal ion containing an element selected from Group IIIA, IVA and VA of the Periodic Table. In some examples, the post-transition metal mentioned herein can be Al, Ga, In, Tl, Sn, Pb, Bi, Hg or any combination thereof.

The term "rare earth metal ion", as used herein, refers to a metal ion containing an element selected from scandium (Sc), yttrium (Y), the lanthanide series of metals (having atomic numbers from 57-71) and the actinide series of metals (having atomic numbers from 89-103) in the Periodic Table. Examples of the rare earth metals in the lanthanide series include La, Ce, Pr, Sm, Gd, Eu, Tb, Dy, Er, Tm, Nd, Yb, or any combination thereof. Examples of the rare earth metals in the actinide series include Ac, Th, Pa, U, Np, Pu, Am, Cm, Bk, Cf, Es, Fm, Md, No, Lr, or any combination thereof.

The term "anion", as used herein, can include a simple anion, a halide anion, a chalcogenide anion, an organic anion, an oxoanion, a pnictide anion, or any combination thereof. Examples of simple anions include those containing O, S, Se, Te, N, P, As, or Sb as a single atom. Examples of halide anions include those containing F, Cl, Br, I, At or any combination thereof (such as $IBr^{-3}$, $Cl_2I^{-3}$, $Br_2I^{-3}$ and $I_2Cl^{-3}$). Examples of chalcogenide anions include those containing S, Se, Te or any combination thereof. Examples of organic anions include acetate ($CH_3COO^-$), formate ($HCOO^-$), oxalate ($C_2O_4^{-2}$), cyanide ($CN^-$) or any combination thereof. Examples of oxoanion include $AsO_4^{-3}$, $AsO_3^{-3}$, $CO_3^{-2}$, $HCO_3^-$, $OH^-$, $NO_3^-$, $NO_2^-$, $PO_4^{-3}$, $HPO_4^{-2}$, $SO_4^{-2}$, $HSO_4^-$, $S_2O_3^{-2}$, $SO_3^{-2}$, $ClO_4^-$, $ClO_3^-$, $ClO_2^-$, $OCl^-$, $IO_3^-$, $BrO_3^-$, $OBr^-$, $CrO_4^-$, $Cr_2O_7^{-2}$ or any combination thereof. Examples of pnictide anions include those containing N, P, As, Sb, or any combination thereof. In some examples, the anion mentioned herein can be an anion containing any combination of O, S, Se, Te, N, P, As, and Sb. In some examples, the anion mentioned herein can be $NCS^-$, $CN^-$, or $NCO^-$.

In some examples, L in formula (I) can include Bi, Tl, Cu, or Hg.

In some examples, D in formula (I) can include C, Si, Ge, Sn, Pb, or Al.

In some examples, B in formula (I) can include Li, Na, K, Rb, or Cs.

In some examples, B' in formula (I) can include La, Mg, Ca, Sr, or Ba.

In some examples, Z in formula (I) can include Li, Na, K, Rb, or Cs.

In some examples, Z' in formula (I) can include Ca or Y.

In some examples, M in formula (I) can include Cu or Fe.

In some examples, A in formula (I) can include O, S, Se, P, or As.

In some examples, the compound presented herein can include crystal structures of multiple compounds of formula (I). In that case, the compound is called a superstructure or an intergrowth.

In some examples, the superconducting compounds of formula (I) can be compounds of formula (II):

$$L_nD_m(B_xB'_{1-x})_r(Z_tZ'_{1-t})_qCu_pO_y \qquad (II),$$

in which n, m, x, r, t, p, q, y, L, D, B, B', Z, and Z' are defined above. In such examples, p can be any number from 1 to 3.

In some examples, the superconducting compounds of formula (I) can be compounds of formula (III):

$$L_nD_m(B_xB'_{1-x})_r(Z_tZ'_{1-t})_qCu_2O_y \qquad (III),$$

in which n, m, x, r, t, q, y, L, D, B, B', Z, and Z' are defined above. In such examples, q can be any number from 1 to 2 and r can be any number from 2 to 4.

Referring to formula (II), a subset of superconducting compounds are those in which q is 0 or 1 and r is any number between 2 and 6. In such examples, L can include Bi, Tl, Cu, Pb, or Hg; n can be between 0 and 4; D can be carbon; m can be any number from 0 to 4; B can include K, Rb, or Cs; B' can include Sr, Ba, Ca and Y; x can be a number from 0.1 to 1; and p can be 1, 2, or 3. Examples of such compound include $Bi_2(K_xSr_{1-x})_2CuO_y$, $Bi_2(Rb_xSr_{1-x})_2CuO_y$, $Bi_2(Cs_xSr_{1-x})_2CuO_y$, $Bi_2C_m(K_xS_{1-x})_4Cu_2O_y$, $Bi_2C_m(Rb_xS_{1-x})_4CaCu_2O_y$, $Bi_2C_m(Cs_xSr_{1-x})_4Cu_2O_y$, $Bi_3C_m(K_xSr_{1-x})_4Cu_2O_y$, $Bi_3C_m(Rb_xSr_{1-x})_4Cu_2O_y$, $Bi_3C_m(Cs_xSr_{1-x})_4Cu_2O_y$, $Bi_4C_m(K_xSr_{1-x})_4Cu_2O_y$, $Bi_4C_m(Rb_xSr_{1-x})_4CaCu_2O_y$, $Bi_4C_m(Cs_xSr_{1-x})_4Cu_2O_y$, $Bi_2C_m(K_xSr_{1-x})_6Cu_3O_y$, $Bi_2C_m(Rb_xSr_{1-x})_6Cu_3O_y$, $Bi_2C_m(Cs_xSr_{1-x})_6Cu_3O_y$, $Bi_3C_m(K_xSr_{1-x})_6Cu_3O_y$, $Bi_3C_m(Rb_xSr_{1-x})_6Cu_3O_y$, $Bi_3C_m(Cs_xSr_{1-x})_6Cu_3O_y$, $Bi_2(K_xSr_{1-x})_4(Sr_tCa_{1-t})Cu_3O_y$, $Bi_2(Rb_xSr_{1-x})_4(Sr_tCa_{1-t})Cu_3O_y$, and $Bi_2(Cs_xSr_{1-x})_4(Sr_tCa_{1-t})Cu_3O_y$.

Referring to formula (III), a subset of superconducting compounds are those in which q is 1 and r is 2. In such examples, L can include Bi, Tl, Cu, Pb, or Hg; n can be 0, 1, or 2; D can be carbon; m can be any number from 0 to 4; B can include K, Rb, or Cs; B' can include Sr; x can be a number from 0.1 to 1; t can be 0; and Z' can include Ca. Examples of such compound include $Bi_2(K_xSr_{1-x})_2CaCu_2O_y$, $Bi_2(Rb_xSr_{1-x})_2CaCu_2O_y$, $Bi_2(Cs_xSr_{1-x})_2CaCu_2O_y$, $Bi_2C_m(K_xSr_{1-x})_2CaCu_2O_y$, $Bi_2C_m(Rb_xSr_{1-x})_2CaCu_2O_y$, and $Bi_2C_m(Cs_xSr_{1-x})_2CaCu_2O_y$.

Referring to formula (III), another subset of superconducting compounds are those in which q is 1, r is 2, and t is a number greater than 0. In such examples, L can include Bi, Tl, or Hg; n can be 0, 1, or 2; D can be carbon; m can be any number from 0 to 4; B can include K, Rb, or Cs; B' can include Sr; x can be a number from 0.1 to 1; and Z' can include Ca. Examples of such compounds include $Bi_2(K_xSr_{1-x})_2(K_tCa_{1-t})Cu_2O_y$, $Bi_2(Rb_xSr_{1-x})_2(Rb_tCa_{1-t})Cu_2O_y$, or $Bi_2(Cs_xSr_{1-x})_2(Cs_tCa_{1-t})Cu_2O_y$, $Bi_2C_m(K_xSr_{1-x})_2(K_tCa_{1-t})Cu_2O_y$, $Bi_2C_m(Rb_xSr_{1-x})_2(Rb_tCa_{1-t})Cu_2O_y$, and $Bi_2C_m(Cs_xSr_{1-x})_2(Cs_tCa_{1-t})Cu_2O_y$.

Referring to formula (II), a subset of superconducting compounds are those in which n is 2, m is a number from 0 to 4, r is a number from 2 to 8, q is a number from 0 to 3, p is 4, L is Bi, B is K, Rb, or Cs, B's is Sr, Z is K, Rb, or Cs, and Z' is Ca. Examples of such compounds include $Bi_2(K_xSr_{1-x})_2(K_tCa_{1-t})_3Cu_4O_y$, $Bi_2(Rb_xS_{r1-x})_2(Rb_tCa_{1-t})_3Cu_4O_y$, $Bi_2(Cs_xSr_{1-x})_2(Cs_tCa_{1-t})_3Cu_4O_y$, $BiC_m(K_xSr_{1-x})_8Cu_4O_y$, $BiC_m(Rb_xSr_{1-x})_8Cu_4O_y$, $BiC_m(Cs_xSr_{1-x})_8Cu_4O_y$, $Bi_2C_m(K_xSr_{1-x})_8Cu_4O_y$, $Bi_2C_m(Rb_xSr_{1-x})_8Cu_4O_y$, $Bi_2C_m(Cs_xSr_{1-x})_8Cu_4O_y$, $Bi_3C_m(K_xSr_{1-x})_8Cu_4O_y$, $Bi_3C_m(Rb_xSr_{1-x})_8Cu_4O_y$, $Bi_3C_m(Cs_xSr_{1-x})_8Cu_4O_y$, $Bi_4(K_xSr_{1-x})4(Sr_tCa_{1-t})_2Cu_4O_y$, $Bi_2(Rb_xSr_{1-x})_4(Sr_tCa_{1-t})_2Cu_4O_y$, and $Bi_2(Cs_xSr_{1-x})_4(Sr_tCa_{1-t})_2Cu_4O_y$.

Referring to formula (II), a subset of superconducting compounds are those in which n is 0, m is a number from 0 to 4, x is 1, t is 1, r is 4, q is 2, p is 4 or 7, B is K, Rb, or Cs, Z is Na. Examples of such compounds include $Na_2K_4Cu_7O_y$, $Na_2Rb_4Cu_7O_y$, $Na_2Cs_4Cu_7O_y$, $Na_2C_mK_4Cu_7O_y$, $Na_2C_mRb_4Cu_7O_y$, $Na_2C_mCs_4Cu_7O_y$, $Na_2C_mK_4Cu_4O_y$, $Na_2C_mRb_4Cu_4O_y$, and $Na_2C_mCs_4Cu_4O_y$.

Referring to formula (II), another subset of superconducting compounds are those in which n is 1, m is a number from 0 to 4, x is 1, t is 0 or 1, r is 2, 4, or 6, q is 0, 1, or 2, p is 1, 2, or 3, L is Hg, B is K, Rb, or Cs, Z is Na, and Z' is Ba. Examples of such compounds include $HgK_2Na_2Cu_3O_y$, $Hg_2CuO_y$, $HgC_mK_4Cu_2O_y$, $HgC_mK_6Cu_3O_y$, $Hg_2K_2Ba_2Cu_2O_y$, and $Hg_3K_2Rb_2Cs_2Cu_3O_y$.

Referring to formula (II), another subset of superconducting compounds are those in which n is 1, 2, or 3, m is a number from 0 to 4, x is 1, t is 0 or 1, r is 2, 4, or 6, q is 0, 1, 2, 3, or 4, p is 1, 2, 3, 4, or 5, L is Tl, B is K, Rb, or Cs, Z is Na, and Z' is Ba. Examples of such compounds include $TlK_2Na_2Cu_3O_y$, $TlK_2CuO_y$, $TlK_2NaCu_2O_y$, $Tl_2K_2Na_4Cu_5O_y$, $TlC_mK_4Cu_2O_y$, $TlC_mK_6Cu_3O_y$, $Tl_2K_2Ba_2Cu_2O_y$, and $Tl_3K_2Rb_2Cs_2Cu_3O_y$.

Referring to formula (II), another subset of superconducting compounds are those in which n is 2, m is a number from 0 to 4, x is 1, t is 1, r is 2, 4, or 6, q is 0 or 2, p is 1 or 3, L is Bi, B is K, and Z is Na. Examples of such compounds include $Bi_2K_2Na_2Cu_3O_y$ $Bi_2K_2CuO_y$, $Bi_2C_mK_6Cu_3O_y$ and $Bi_2C_mK_4CuO_y$.

Referring to formula (II), another subset of superconducting compounds are those in which n is a number from 0 to 1, m is a number from 0 to 1, x is a number from 0.1 to 1, r is 2 or 4, t is a number from 0 to 1, q is 0, 1, or 2, p is 2, 3, or 6, L is Y, B is K, Rb, or Cs, B' is Sr or Ba, Z is Na, K, Rb, or Cs, and Z' is Y. Examples of such compounds include $Y(K_xBa_{1-x})_2Cu_3O_y$, $Y(Rb_xBa_{1-x})_2Cu_3O_y$, $Y(Cs_xBa_{1-x})_2Cu_3O_y$, $(Y_{1-t}Na_t)(Cs_{1-x}Ba_x)_2Cu_3O_y$, $(Y_{1-t}Na_t)(Cs_xBa_{1-x})_2Cu_4O_y$, $(Y_{1-t}Na_t)_2(Cs_xBa_{1-x})_4Cu_7O_y$, $Y((CsK)_xBa_{1-x})_2Cu_3O_y$, $(Y_nSr_{1-n})(Cu_{1-m}C_m)(K_xSr_{1-x})_2Cu_2O_y$, $(Y_nSr_{1-n})(Cu_{1-m}C_m)(Rb_xSr_{1-x})_2Cu_2O_y$, $(Y_nSr_{1-n})(Cu_{1-m}C_m)(Cs_xSr_{1-x})_2Cu_2O_y$, and $(Y_nSr_{1-n})(Cu_{1-m}C_m)(Rb_xCs_{1-x})_2Cu_2O_y$.

Referring to formula (II), another subset of superconducting compounds are those in which n is 0 or 1, m is a number from 0 to 1, x is a number from 0 to 1, r is 2 or 4, t is a number from 0 to 1, q is 1, p is 2, 3, 4, 5, or 6, L is Cu, B is K, Rb, or Cs, B' is Ba, and Z is Na. Examples of such compounds include $Na(K_xBa_{1-x})_2Cu_3O_y$, $Na(Rb_xBa_{1-x})_2Cu_3O_y$, $Na(Cs_xBa_{1-x})_2Cu_3O_y$, $Na((CsK)_xBa_{1-x})_2Cu_3O_y$, $NaBa_2Cu_3O_y$, $Na_2Ba_4Cu_7O_y$, $NaBa_2Cu_4O_y$, $(Cu_{1-m}C_m)(K_xSr_{1-x})_2(Na_tSr_{1-t})Cu_2O_y$, $(Cu_{1-m}C_m)(Rb_xSr_{1-x})_2(Na_tSr_{1-t})Cu_2O_y$, $(Cu_{1-m}C_m)(Cs_xSr_{1-x})_2(Na_tSr_{1-t})Cu_2O_y$, $(Cu_{1-m}C_m)(Rb_xCs_{1-x})_2(Na_tSr_{1-t})Cu_2O_y$, $CuC_m(K_xBa_{1-x})_2Cu_pO_y$, $CuC_m(Rb_xBa_{1-x})_2Cu_pO_y$, and $CuC_m(Cs_xBa_{1-x})_2Cu_pO_y$.

In some examples, B' is a metal ion having a first atomic number, Z' is a metal ion having a second atomic number, and the second atomic number is smaller than the first atomic number. For example, B' can be a metal ion containing Sr or Ba and Z' can be a metal ion containing Ca.

In some examples, x in formula (I) ranges from 0.1 to 1 (e.g., from 0.2 to 1, from 0.3 to 1, from 0.4 to 1, from 0.5 to 1, from 0,55 to 1, from 0.6 to 1, from 0.65 to 1, from 0.7 to 1, from 0.75 to 1, from 0.8 to 1, from 0.85 to 1, from 0.9 to 1, from 0.95 to 1, from 0.97 to 1, from 0.98 to 1, or from 0.99 to 1). In some examples, x in formula (I) is 1. Without wishing to be bound by theory, it is believed that increasing the value of x can increase the critical temperature (Tc) of a superconducting compound of formula (I) as an increasing amount of the B' ion (i.e., alkaline earth metal ions or rare earth metal ions) in the crystal structure in the compound of formula (I) is replaced by the B ion (i.e., an alkali metal ion).

In some examples, t in formula (I) ranges from 0.1 to 1 (e.g., from 0.2 to 1, from 0.3 to 1, from 0.4 to 1, from 0.5 to 1, from 0.6 to 1, from 0.7 to 1, from 0.8 to 1, from 0.9 to 1, from 0.95 to 1, from 0.98 to 1, or from 0.99 to 1). In some examples, t in formula (I) is 1. Without wishing to be bound by theory, it is believed that increasing the value of t (e.g., when t is above 0.5) can increase Tc of a superconducting compound of formula (I) as an increasing amount of the Z' ion (i.e., alkaline earth metal ions or rare earth metal ions) in the crystal structure in the compound of formula (I) is replaced by the Z ion (i.e., an alkali metal ion).

In some examples, n in formula (I) can be any number (e.g., an integer or a non-integer) from 0 to 3. For example, n can be any number from 0.1 to 2.9 (e.g., from 0.2 to 2.8, from 0.3 to 2.7, from 0.4 to 2.6, from 0.5 to 2.5, from 0.6 to 2.4, from 0.7 to 2.3, from 0.8 to 2.2, from 0.9 to 2.1, from 1 to 2, from 1.1 to 1.9, from 1.2 to 1.8, from 1.3 to 1.7, from 1.4 to 1.6, or 1.5).

In some examples, m in formula (I) can be any number (e.g., an integer or a non-integer) from 0 to 6. For example, n can be any number from 0.1 to 5.9 (e.g., from 0.2 to 5.8, from 0.3 to 5.7, from 0.4 to 5.6, from 0.5 to 5.5, from 0.6 to 5.4, from 0.7 to 5.3, from 0.8 to 5.2, from 0.9 to 5.1, from 1 to 5, from 1.1 to 4.9, from 1.2 to 4.8, from 1.3 to 4.7, from 1.4 to 4.6, from 1.5 to 4.5, from 1.6 to 4.4, from 1.7 to 4.3, from 1.8 to 4.2, from 1.9 to 4.1, from 2 to 4, from 2.1 to 3.9, from 2.2 to 3.8, from 2.3 to 3.7, from 2.4 to 3.6, from 2.5 to 3.5, from 2.6 to 3.4, from 2.7 to 3.3, from 2.8 to 3.2, from 2.9 to 3.1, or 3). In some examples, the sum of n and m is an integer.

In some examples, r in formula (I) can be any number (e.g., an integer or a non-integer) from 1 to 8. For example, r can be any number from 1.1 to 7.9 (e.g., from 1.2 to 7.8, from 1.3 to 7.7, from 1.4 to 7.6, from 1.5 to 7.5, from 1.6 to 7.4, from 1.7 to 7.3, from 1.8 to 7.2, from 1.9 to 7.1, from 2 to 7, from 2.1 to 6.9, from 2.2 to 6.8, from 2.3 to 6.7, from 2.4 to 6.6, from 2.5 to 6.5, from 2.6 to 6.4, from 2.7 to 6.3, from 2.8 to 6.2, from 2.9 to 6.1, from 3 to 6, from 3.1 to 5.9, from 3.2 to 5.8, from 3.3 to 5.7, from 3.4 to 5.6, from 3.5 to 5.5, from 3.6 to 5.4, from 3.7 to 5.3, from 3.8 to 5.2, from 3.9 to 5.1, from 4 to 5, from 4.1 to 4.9, from 4.2 to 4.8, from 4.3 to 4.7, from 4.4 to 4.6, or 4.5).

In some examples, q in formula (I) can be any number (e.g., an integer or a non-integer) from 0 to 6. For example, q can be any number from 0.1 to 5.9 (e.g., from 0.2 to 5.8, from 0.4 to 5.6, from 0.6 to 5.4, from 0.8 to 5.2, from 1 to 5, from 1.2 to 4.8, from 1.4 to 4.6, from 1.6 to 4.4, from 1.8 to 4.2, from 2 to 4, from 2.2 to 3.8, from 2.4 to 3.6, from 2.6 to 3.4, or from 2.8 to 3.2).

In some examples, p in formula (I) can be any number (e.g., an integer or a non-integer) from 0 to 7. For example, p can be any number from 0.1 to 6.9 (e.g., from 0.2 to 6.8, from 0.4 to 6.6, from 0.6 to 6.4, from 0.8 to 6.2, from 1 to 6, from 1.2 to 5.8, from 1.4 to 5.6, from 1.6 to 5.4, from 1.8 to 5.2, from 2 to 5, from 2.2 to 4.8, from 2.4 to 4.6, from 2.6 to 4.4, from 2.8 to 4.2, from 3 to 4, from 3.2 to 3.8, from 3.4 to 3.6, or 3.5).

In some examples, a superconducting compound described herein is a crystalline metal oxide containing at least one transition metal ion (e.g., a Cu ion) and at least one alkaline earth metal ion (e.g., a Sr or Ba ion) or at least one rare earth metal ion,,in which from 10% to 100% of the at least one alkaline earth metal ion or at least one rare earth metal ion (i.e., in the crystal structure) is replaced by an alkali metal ion (e.g., an ion of Li, Na, K, Rb, or Cs). Examples of the crystalline metal oxides before modification include $Bi_2Sr_2CaCu_2O_y$ (Bi2212) and $YBa_2Cu_3O_7$ (YBCO). In some examples, the superconducting compound is a crystalline metal oxide described above in which from 20% to 100% (e.g., from 30% to 100%, from 40% to 100%, from 50% to 100%, from 60% to 100%, from 70% to 100%, from 80% to 100%, from 90% to 100%, from 95% to 100%, from 99% to 100%, or 100%) of the at least one alkaline earth metal ion or at least one rare earth metal ion in the crystal structure is replaced by an alkali metal ion. Without wishing to be bound by theory, it is believed that a superconducting metal oxide in which a higher amount (e.g., more than 50%) of an alkaline earth metal ion in its crystal structure is replaced by an alkali metal ion would exhibit a higher Tc based on the model described below.

In some examples, the crystalline metal oxide described above can further include a post-transition metal ion (e.g., an ion of Bi or Tl) or a transition metal ion (e.g., a Hg ion), such as those described above. In some examples, the crystalline metal oxide described above can include a rare earth metal ion, such as those described above.

In some examples, the crystalline metal oxide described above can include two or more (e.g., three or four) alkaline earth metal ions (e.g., Sr, Ba, and/or Ca ions). In such examples, only one of the alkaline earth metal ions can be replaced by an alkali metal ion or two or more of the alkaline earth metal ions can be replaced by alkali metal ions.

In some examples, when two or more alkaline earth metal ions in a crystalline metal oxide are replaced by two or more alkali metal ions, each of alkaline earth metal ion can be replaced by any one of the two or more alkali metal ions.

In some examples, a superconducting compound described herein (e.g., a compound of formula (I)) is a compound having a crystal structure, where the crystal structure includes a plurality of cell units, at least 10% of the cell units include a cluster (e.g., a sub cell unit); the cluster includes a plurality of anions (e.g., O anions), a plurality of transition metal ions (e.g., Cu ions), and at least one alkali metal ion (e.g., ions of Li, Na, K, Rb, and Cs); each transition metal ion forms a covalent bond with at least one anion; the plurality of anions define a plane; the at least one alkali metal ion is located approximate to the plane; the distance between the at least one alkali metal ion and the plane is less than twice of the radius of the at least one alkali metal ion; and at least two of the plurality of anions have a distance of from 3.8 Å to 4.2 Å. In some examples, the at least two of the plurality of anions can have a distance of at least 3.8 Å (e.g., at least 3.85 Å, or at least 3.9 Å) and/or at most 4.2 Å (e.g., at most 4.15 Å, at most 4.1 Å, at most 4.05 Å, or at most 4 Å). In some examples, at least 20% (e.g., at least 30%, at least 40%, at least 50%, at least 60%, at least 70%, at least 80%, at least 90%, at least 95%, or at least 99%) of the cell units in the crystal structure include the cluster described above (which contains at least one alkali metal ion). In some examples, other anions and metal ions described above can be used in addition to the cluster to form a superconducting compound. For example, a charge reservoir layer or a doping mechanism (e.g., interstitial ions) can be included in addition to the cluster to form a superconducting compound.

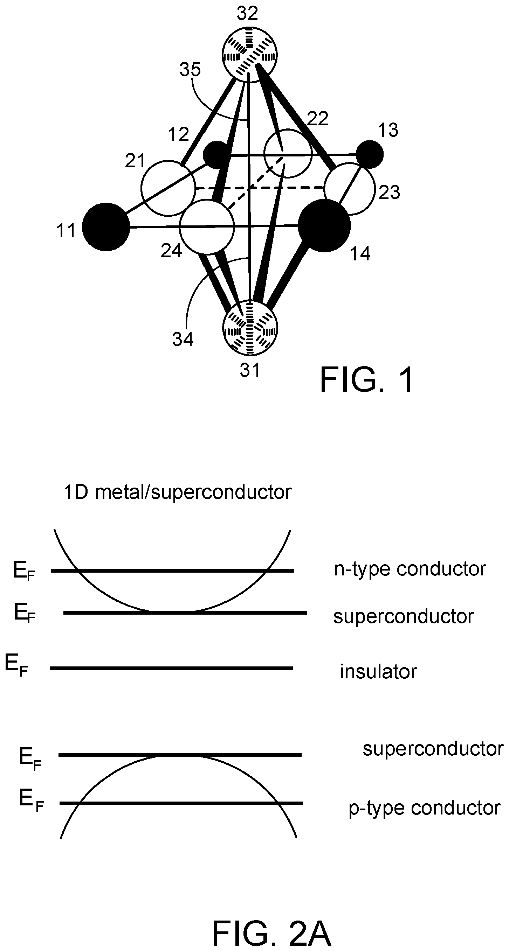

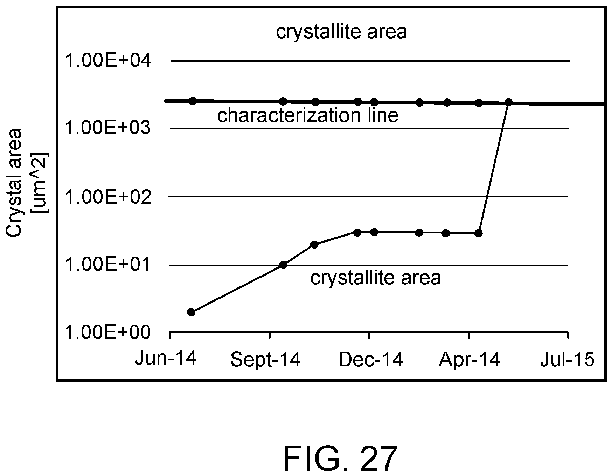

FIG. 1 illustrates a crystal structure that includes an exemplary cluster (i.e., an octahedral cluster) described above that includes four in-plane ions and two buffer ions (e.g., an alkali metal ion and an alkaline earth metal ion or a transition metal ion). As shown in FIG. 1, the cluster includes anions 21, 22, 23, and 24 (e.g., O anions), transition metal ions 11, 12, 13, and 14 (e.g., Cu ions), and two buffer ions 31 and 32, at least one of which is an alkaline metal ion (e.g., ions of Li, Na, K, Rb, and Cs). Each of transition metal ions 11, 12, 13, and 14 forms a covalent bond with a neighboring anion. Transition metal ions 11, 12, 13, and 14 and anions 21, 22, 23, and 24 form a plane in which metal ions 11, 12, 13, and 14 are located at the vertices of the plane, and anions 21, 22, 23 and 24 are located at the edges of the plane. The distance 34 or 35 between the buffer ion 31 or 32 and the plane is less than twice of the radius of the buffer ion. In some embodiment, when alkali metal ion 31 is the same as the alkali metal ion 32, the distance 34 is substantially similar to the distance 35. The distance between two anions facing each other (i.e., the distance between anions 21 and 23 or the distance between anions 22 and 24) in the plane is from 3.8 Å to 4.2 Å. In some embodiment, ion 31 is an alkali metal ion and ion 32 is a different ion (e.g., an alkaline earth metal ion or a transition metal ion). An example of such a cluster, containing an alkali metal ion Rb, is identified in the x-ray crystallography as shown in Fig. 27.

In some examples, a superconducting compound of formula (I) can include a cluster (e.g., a sub cell unit in the crystal structure of the compound) having a formula of $BZMA_2$ or $BZ'MA_2$, in which B, Z, Z', M, and A are defined above.

Without wishing to be bound by theory, it is believed that the cluster described herein (e.g., a cluster having a structure of $BZMA_2$ or $BZ'MA_2$) is primarily responsible for the high Tc and superconducting activities/properties at a high temperature (e.g., at least about 150K). Thus, without wishing to be bound by theory, it is believed that all crystalline compounds (e.g., metal oxide crystalline compounds) having such a cluster would exhibit high Tc and superconducting activities/properties at a high temperature.

In some examples, a superconducting compound described herein includes at least 15% (e.g., at least 20%, at least 25%, at least 30%, at least 35%, at least 40%, at least 45%, at least 50%, at least 55%, at least 60%, at least 65%, at least 70%, at least 75%, at least 80%, at least 85%, at least 90%, at least 95%, at least 98%, at least 99%, or 100%) of cell units that have the cluster described above (e.g., such as that shown in FIG. 1) in its crystal structure. Without wishing to be bound by theory, it is believed that a superconducting compound containing a higher amount (e.g., more than 50%) of the cluster described above would exhibit a higher Tc based on the model described below. In some examples, a superconducting compound described herein further contains one or more clusters similar to that shown in FIG. 1 except that the alkali metal ion is replaced by an alkaline earth metal ion (e.g., Ca, Sr, or Ba) or a rare earth metal ion (e.g., La).

In some examples, a superconducting compound containing the cluster described above can further include a transition metal ion or a post-transition metal ion, such as the L ion in formula (I). Without wishing to be bound by theory, it is believed that additional anions attached to the L ion can be considered as doping ions for the cluster described above so as to render the plane formed by anions 21, 22, 23, and 24 conducting. Further, without wishing to be bound by theory, it is believed that such a doping effect can facilitate the formation of the superconductivity of the compound.

In some examples, the cluster described above can include only two anions, which have a distance of from 3.8 Å to 4.2 Å. In such examples, the other metal ions in the cluster can be located at any locations in space so as to keep the two anions at the above distance. Any reference to the plane formed by anions 21, 22, 23, and 24 defined above can now be replaced by the line connecting these two anions. In some examples, a superconducting compound having such a cluster (e.g., a sub cell unit in the crystal structure of the compound) can have a formula of $BMA_2$, in which B, M, and A are defined above.

In some examples, the superconducting compounds described herein can include (1) from 0 at% to 30 at% of a first metal ion selected from the group consisting of transition metal ions and post-transition metal ions; (2) from 1 at% to 20 at% of a second metal ion, the second metal ion being an alkali metal ion; (3) from 0 at% to 30 at% of a third metal ion selected from the group consisting of alkaline earth metal ions and rare earth metal ions; (4) from 0 at% to 30 at% of a fourth metal ion selected from the group consisting of alkaline earth metal ions and rare earth metal ions, the fourth metal ion being different from the third metal ion; (5) from 10 at% to 30 at% of a fifth metal ion, the fifth metal ion being a transition metal ion and being different from the first metal ion; (6) from 0 at% to 30 at% of a Group IIIA or IVA element; and (7) from 10 at% to 60 at% of an anion. As used herein, the unit "at%" refers to atomic percentage. The transition metal ions, post-transition metal ions, alkali metal ions, alkaline earth metal ions, rare earth metal ions, and anions can be the same as those described above.

In some examples, the first metal ion can be at least 1 at% (e.g., at least 2 at%, at least 3 at%, at least 4 at%, at least 5 at%, at least 6 at%, at least 7 at%, at least 8 at%, at least 9 at%, at least 10 at%, at least 11 at%, at least 12 at%, at least 13 at%, at least 14 at%, or at least 15 at%) and/or at most 30 at% (e.g., at most 29 at%, at most 28 at%, at most 27 at%, at most 26 at%, at most 25 at%, at most 24 at%, at most 23 at%, at most 22 at%, at most 21 at%, at most 20 at%, at most 19 at%, at most 18 at%, at most 17 at%, at most 16 at%, or at most 15 at%) of a superconducting compound described herein.

In some examples, the second metal ion can be at least 1 at% (e.g., at least 2 at%, at least 3 at%, at least 4 at%, at least 5 at%, at least 6 at%, at least 7 at%, at least 8 at%, at least 9 at%, or at least 10 at%) and/or at most 20 at% (e.g., at most 19 at%, at most 18 at%, at most 17 at%, at most 16 at%, at most 15 at%, at most 14 at%, at most 13 at%, at most 12 at%, at most 11 at%, or at most 10 at%) of a superconducting compound described herein.

In some examples, each of the third and four metal ions, independently, can be at least 0 at% (e.g., at least 1 at%, at least 2 at%, at least 3 at%, at least 4 at%, at least 5 at%, at least 6 at%, at least 7 at%, at least 8 at%, at least 9 at%, at least 10 at%, at least 11 at%, at least 12 at%, at least 13 at%, at least 14 at%, or at least 15 at%) and/or at most 30 at% (e.g., at most 29 at%, at most 28 at%, at most 27 at%, at most 26 at%, at most 25 at%, at most 24 at%, at most 23 at%, at most 22 at%, at most 21 at%, at most 20 at%, at most 19 at%, at most 18 at%, at most 17 at%, at most 16 at%, or at most 15 at%) of a superconducting compound described herein.

In some examples, the fifth metal ion can be at least 10 at% (e.g., at least 11 at%, at least 12 at%, at least 13 at%, at least 14 at%, at least 15 at%, at least 16 at%, at least 17 at%, at least 18 at%, at least 19 at%, or at least 20 at%) and/or at most 30 at% (e.g., at most 29 at%, at most 28 at%, at most 27 at%, at most 26 at%, at most 25 at%, at most 24 at%, at most 23 at%, at most 22 at%, at most 21 at%, or at most 20%) of a superconducting compound described herein.

In some examples, the Group IIIA or IVA element can be at least 0 at% (e.g., at least 1 at%, at least 2 at%, at least 3 at%, at least 4 at%, at least 5 at%, at least 6 at%, at least 7 at%, at least 8 at%, at least 9 at%, or at least 10 at%) and/or at most 30 at% (e.g., at most 29 at%, at most 28 at%, at most 27 at%, at most 26 at%, or at most 25 at%, at most 24 at%, at most 23 at%, at most 22 at%, at most 21 at%, or at most 20 at%, at most 19 at%, at most 18 at%, at most 17 at%, at most 16 at%, or at most 15 at%) of a superconducting compound described herein.

In some examples, the anion can be at least 10 at% (e.g., at least 11 at%, at least 12 at%, at least 13 at%, at least 14 at%, at least 15 at%, at least 16 at%, at least 17 at%, at least 18 at%, at least 19 at%, at least 20 at%, at least 21 at%, at least 22 at%, at least 23 at%, at least 24 at%, at least 25 at%, at least 26 at%, at least 27 at%, at least 28 at%, at least 29 at%, at least 30 at%, at least 31 at%, at least 32 at%, at least 33 at%, at least 34 at%, or at least 35 at%) and/or at most 60 at% (e.g., at least 59 at%, at most 58 at%, at least 57 at%, at most 56 at%, at least 55 at%, at most 54 at%, at least 53 at%, at most 52 at%, at least 51 at%, at most 50 at%, at least 49 at%, at most 48 at%, at least 47 at%, at most 46 at%, at least 45 at%, at most 44 at%, at least 43 at%, at most 42 at%, at least 41 at%, at most 40 at%, at least 39 at%, at least 38 at%, at least 37 at%, at least 36 at%, or at least 35 at%) of a superconducting compound described herein.

In some examples, the superconducting compounds described herein are substantially pure. For example, the superconducting compounds can have a purity of at least 50% (e.g., at least 60%, at least 70%, at least 80%, at least 90%, at least 95%, at least 98%, at least 99%, or 100%).

In general, the compounds described herein can be superconductors (e.g., capable of carrying superconductive current) at a relatively high temperature. In some examples, the superconducting compounds described herein can be a superconductor at the temperature of at least 150K (e.g., at least 160K, at least 170K, at least 180K, at least 190K, at least 200K, at least 210K, at least 220K, at least 230K, at least 240K, at least 250K, at least 260K, at least 270K, at least 273K, at least 283K, at least 293K, at least 300K, at least 320K, at least 340K, at least 360K, at least 380K, or at least 400K) and/or at most about 500K (e.g., at most about 480K, at most about 460K, at most about 450K, at most about 440K, at most about 420K, or at most about 400K). In some examples, the superconducting compounds described herein can have Tc of at least 150K (e.g., at least 160K, at least 170K, at least 180K, at least 190K, at least 200K, at least 210K, at least 220K, at least 230K, at least 240K, at least 250K, at least 260K, at least 270K, at least 273K, at least 283K, at least 293K, at least 300K, at least 320K, at least 340K, at least 360K, at least 380K, or at least 400K) and/or at most 500K (e.g., at most 480K, at most 460K, at most 450K, at most 440K, at most 420K, or at most 400K). Without wishing to be bound by theory, it is believed that crystalline compounds having the cluster structure described above can exhibit a high Tc based on the model described below.

In some examples, this disclosure features a composition containing a superconducting compound described herein. In such examples, the composition can contain at least 1% (e.g., at least 2%, at least 3%, at least 5%, at least 10%, at least 20%, at least 30%, at least 40%, or at least 50%) and/or at most about 99.9% (e.g., at most 99%, at most 98%, at most 95%, at most 90%, at most 80%, at most 70%, at most 60%, or at most 50%) of the superconducting compound.

In some examples, this disclosure features a method of forming a superconducting compound. The method can include (1) mixing a crystalline metal oxide with an alkali metal salt containing an alkali metal ion (e.g., an ion of Li, Na, K, Rb, or Cs) to form a mixture, in which the metal oxide contains at least one transition metal ion (e.g., a Cu ion) and at least one alkaline earth metal ion (e.g., a Ca, Sr, or Ba ion) and the atomic ratio between the alkali metal ion and the at least one alkaline earth metal ion is higher than 1:1; and (2) sintering the mixture at an elevated temperature to form a crystalline compound containing the alkali metal ion. Suitable crystalline metal oxides that can be used as starting materials to prepare the superconducting compounds described herein include for example Bi2212, YBCO, Bi2223, Tl2212, Tl2223, Hg1201, Hg1212, and Hg1223. Thus, in some examples, the superconducting compounds of formula (I) can be prepared by the above manufacturing method using a corresponding metal oxide and a suitable alkali metal salt as starting materials.

In some examples, when the superconducting compounds of formula (I) contain an element D, the element D can be introduced into the superconducting compounds by adding a salt (e.g., an alkali metal salt) containing element D in the mixture described in step (1) above. Suitable salts containing element D that can be used to prepare the superconducting compounds described herein include for example $K_2CO_3$, $K_2SiO_3$, $K_2B_4O_7$, $Rb_2CO_3$, $Rb_2SiO_3$, $Cs_2CO_3$, $Cs_2SiO_3$, $KHCO_3$, $RbHCO_3$ or $CsHCO_3$. For example, to prepare the superconducting compounds of formula (I) containing an element D where D is carbon, an alkali metal salt containing carbon (e.g., $K_2CO_3$, $Rb_2CO_3$, or $Cs_2CO_3$) can be used in step (1) described above. In addition the superconducting compounds described herein in which D is carbon can be prepared by sintering a crystalline metal oxide and an alkali metal salt under a flow of $CO_2$ to induce incorporation of carbon in the structure. It is believed that carbon atoms, if imbedded in the crystal structure, can facilitate the incorporation of alkali ions in the crystal.

In some examples, the atomic ratio (i.e., the molar ratio) between the alkali metal ion in the alkali metal salt and the at least one alkaline earth metal ion in the metal oxide is at least 1.3:1 (e.g., at least 1.5:1, at least 1.7:1, at least 2:1, at least 2.3:1, at least 2.5:1, at least 2.7:1, at least 3:1, at least 4:1, at least 5:1, at least 6:1, at least 7:1, at least 8:1, at least 9:1, at least 10:1, at least 11:1, at least 12:1, at least 13:1, at least 14:1, at least 15:1, or at least 16:1). In some examples, when the metal oxide starting material contains two or more alkaline earth metal ions, the atomic ratio described above can be between the alkali metal ion in the alkali metal salt and one of the two or more alkaline earth metal ions in the metal oxide. Without wishing to be bound by theory, it is believed that using an excess amount (e.g., more than 1:1 atomic ratio) of an alkali metal salt in the method described above can facilitate replacement of the alkaline earth metal ion in the crystal structure of the metal oxide compound by the alkali metal ion. Further, without wishing to be bound by theory, it is believed that a superconducting metal oxide containing a higher amount of an alkali metal ion in its crystal structure would exhibit a higher Tc based on the model described below.

In general the sintering temperature of used in the method described can depend on various factors such as the structure of the compound to be synthesized and their melting temperatures. In some examples, the sintering temperature is at least 300°C (e.g., at least 400°C, at least 500°C, at least 600°C, at least 700°C, at least 750°C, or at least 800°C) and/or at most 1200°C (e.g., at most 1100°C, at most 1000°C, at most 900°C, at most 850°C, at most 820°C, or at most 800°C). The sintering time (or the dwelling time) can be at least 20 hours (e.g., at least 30 hours, at least 40 hours, at least 50 hours, at least 100 hours, or at least 150 hours) and/or at most 300 hours (e.g., at most 280 hours, at most 250 hours, at most 220 hours, at most 200 hours, or at most 150 hours).

In some examples, the mixture of a crystalline metal oxide and an alkali metal salt can be sintered at a first temperature for a first period of time and then sintered at a second temperature different from the first temperature for a second period time. In some examples, the second temperature can be higher than the first temperature. The first or second temperature can be at least 750°C (e.g., at least 760°C, at least 770°C, at least 780°C, at least 790°C, at least 800°C, or at least 810°C) and/or at most 850°C (e.g., at most 840°C, at most 830°C, at most 820°C, at most 810°C, at most 800°C).

In some examples, this disclosure features a device that is superconductive (e.g., exhibiting superconductive properties such as capable of carrying a superconductive current) at a temperature of at least 150K (e.g., at least 180K, at least 200K, at least 230 K, at least 250K, at least 273K, at least 278K, at least 283K, at least 288K, at least 293K, at least 298K, at least 300K, at least 305K, or at least 310K). Exemplary devices include cables, magnets, levitation devices, superconducting quantum interference devices (SQUIDs), bolometers, thin film devices, motors, generators, current limiters, superconducting magnetic energy storage (SMES) devices, quantum computers, communication devices, rapid single flux quantum devices, magnetic confinement fusion reactors, beam steering and confinement magnets (such as those used in particle accelerators), RF and microwave filters, and particle detectors.

Without wishing to be bound by theory, the inventor believes that the high temperature superconducting compounds and methods of making such compounds are based on the principles and model described in more detail below.

It is believed that superconductive behavior of charge carriers arises as a result of nearly degenerate dispersion relation $\varepsilon(\mathbf{k})$ of a material, at proximity to the Fermi level thereof. Accordingly, the complete many-body Hamiltonian is simplified to a residual Hamiltonian, formally similar to the reduced Hamiltonian postulated by the well-known BCS model [Bardeen, et. al., Phys. Rev. 108, 1175 (1957)], while maintaining a connection between prediction of superconducting behavior and electronic and chemical structure of a corresponding material composition through the Schrodinger equation. More specifically, the nearly degenerate dispersion relation may be a result of little overlap between electronic states. This allows prediction of superconducting behavior as a result of calculation of electronic states in small atomic clusters providing reasonable accuracy of meV (mili electron Volt).

Thus, it is believed that materials suspected as providing superconducting behavior may be identified by the use of energy state computation for energies of at least two electronic states associated with a corresponding atomic cluster. Such an atomic cluster generally includes a plurality of atoms of at least one candidate element/species being neutral atoms, cations and anions. The calculation utilizes geometrical characterization of the atomic structure including distances between the elements of the cluster. It should be noted that the computation may generally include variation of one or more distances and which may imply that certain atoms of the cluster are to be replaced with others. The frontier molecular orbitals of the cluster should be identified by the appropriate calculation and such frontier molecular orbitals having relatively low overlap may be detected. The frontier molecular orbitals generally relate to Highest Occupied Molecular Orbital (HOMO) and the Lowest Unoccupied Molecular Orbital (LUMO).

Additionally, the band structure of a similar superconducting compound can be calculated to provide an estimation of the corresponding Fermi level. The atomic cluster may be varied to provide that the Fermi level lays in proximity with the energetic level the identified low overlap frontier molecular orbitals.

The compound described by the calculated atomic cluster may be determined as having high probability to exhibit superconducting behavior if the selected low overlap frontier molecular orbital show that bonding and anti-bonding energies are different by less than about 150 meV (e.g., less than 100 meV, or preferably less than 50 meV) and/or more than 1 meV (e.g., more than 5 meV or more than 10 meV). Usually such atomic clusters have high separation between adjacent energy levels. It is believed that one should look for such cases where the highest levels of the cluster, preferably the ground state and the first excited state are intrinsically nearly degenerate.

In some examples, the inventor believes that the following analysis provides a basis for identifying a superconducting material and a method of making such a superconducting material.

Starting with a full Hamiltonian expression including the kinetic energy, the phonon part, the electron-phonon interaction and the electron-electron interaction:

$$H = \varepsilon_0 \sum_k c_k^\dagger c_k + \sum_k (\varepsilon_k - \varepsilon_0) c_k^\dagger c_k + \sum_q \omega_q \left( a_q^\dagger a_q + \frac{1}{2} \right) + \sum_{q,k} M_q c_{k+q}^\dagger c_k \left( a_q^\dagger + a_{-q} \right) + \sum_{q,k,k'} v(q) c_{k+q}^\dagger c_{k'+q}^\dagger c_{k'} c_k \tag{1}$$

where $\varepsilon_0 = \mu$ is the chemical potential (to be determined); $\varepsilon_k$ is the normal quasiparticle energy; $c_k^\dagger$ and $c_k$ are electronic creation and destruction operators respectively; $a_q^\dagger$ and $a_q$ are phononic creation and destruction operators respectively; $\omega_q$ is the phonon frequency, $M_q$ is an electron-phonon matrix element and $v(q)$ is a screened Coulombic potential. The Hamiltonian of equation (1) is simplified utilizing the standing wave assumption:

$$\nabla_k \varepsilon = 0 \tag{2}$$

This assumption states that all of the electronic $k$ states are degenerate, i.e. having similar energy. Additionally, based on the assumption that the second term in equation (1) is a small perturbation, the following transformation introduces renormalized phonon operators:

$$A_q = a_q + \frac{M_q^*}{\omega_q} \sum_k c_{k-q}^+ c_k \tag{3}$$

Using the standing wave assumption for electronic density operator provides:

$$\rho_1(q,t) = \sum_k c_{k-q}^+(t) c_k(t) = \sum_k c_{k-q}^+ e^{\frac{i}{\hbar}\varepsilon_0 t} c_k e^{-\frac{i}{\hbar}\varepsilon_0 t} = \rho_1(q) \tag{4}$$

and similarly the square density operator:

$$\rho_2(q,t) = \sum_{k,k'} c_{k-q}^+(t) c_{k'+q}^+(t) c_{k'}(t) c_k(t) = \rho_2(q) \tag{5}$$

indicating that the electronic density $\rho_1(q)$ is a constant of the motion and that $A_q$ retains the canonical relations (boson commutation relations):

$$\left[ A_q, A_{q'}^+ \right] = \delta_{q,q'} \quad , \quad \left[ A_q^+, A_{q'}^+ \right] = 0 = \left[ A_q, A_{q'} \right] \tag{6}$$

The renormalized phonon density expression provides:

$$\sum_q \omega_q A_q^+ A_q = \sum_q \omega_q a_q^+ a_q + \sum_q M_q \left( a_q + a_{-q}^+ \right) \sum_k c_{k+q}^+ c_k +$$

$$+ \frac{|M_q|^2}{\omega_q} \left( \sum_k c_{k-q}^+ c_k \right) \left( \sum_{k'} c_{k'+q}^+ c_{k'} \right) \tag{7}$$

using $M_{-q}^* = M_q$ and rearranged the summation order.

Using the renormalized phonon operator in the Hamiltonian of equation (1), the Hamiltonian can be diagonalized under the standing wave condition of equation (2) while neglecting the kinetic energy term as a perturbation:

$$H_0 = \varepsilon_0 N + \sum_q \omega_q \left( A_q^+ A_q + \frac{1}{2} \right) + \sum_q \left( v(q) - \frac{|M_q|^2}{\omega_q} \right) \rho_2(q) \tag{8}$$

This provides pairing correlation $\rho_2(q)$ as a result of the standing wave assumption (2) and canonical transformation (3).

The kinetic energy term can be treated as a perturbation

$$H_1 = \sum_k \left( \varepsilon_k - \varepsilon_0 \right) c_k^+ c_k \tag{9}$$

i.e. $H = H_0 + H_1$. After diagonalizing the standing waves Hamiltonian $H_0$, the electronic residue remains in the equation:

$$H_e = \sum_k \left( \varepsilon_k - \varepsilon_0 \right) c_k^+ c_k + \sum_q \left( v(q) - \frac{|M_q|^2}{\omega_q} \right) \rho_2(q) \tag{10}$$

in resemblance to the well known *reduced* BCS Hamiltonian [Bardeen, et al., Phys. Rev. 108, 1175 (1957)]. The anticipated quasi-particle interactions with the phonons and among themselves are neglected in the low quasi-particle density (low temperature) limit. Following BCS, these interactions can be considered to be similar as in the normal state. It should be noted that no pairing is assumed. It arises from the assumption of standing wave behavior.

Based on the BCS theory,

$$\langle \Psi | H_e - \mu N - \Sigma_q \lambda_q \rho_2(q) | \Psi \rangle = \Sigma_k 2\varepsilon_k |v_k|^2 + \Sigma_q \left( v(q) - \frac{|M_q|^2}{\omega_q} - \lambda_q \right) \rho_2(q) \tag{11}$$

where $\lambda_q$ is a Lagrange multiplier relating to the constraint of constant square density:

$$\frac{\partial}{\partial t} \rho_2(q) = 0 \tag{12}$$

Equation (11) derives an energy gap, which is formally similar to that predicted by BCS:

$$\tag{13}$$

$$\Delta_k = \frac{1}{2} \sum_{k'} (V_{kk'} - \lambda_q) \frac{\Delta_{k'}}{E_{k'}} \qquad\qquad E_k = \sqrt{\xi_k^2 + \Delta_k^2} \tag{13}$$

The BCS theory is therefore found to be embedded in the standing wave theory. The ground state is found to be a condensate of non-dispersing standing electronic wave functions. The excited states are dispersive quasi-particle electronic states (bogolons). It also should be noted that the electronic operators $c^+$ and $c$ in equation (9) are understood as perturbed standing wave states.

Additionally, the electrodynamics of superconducting materials can be derived from the London equations. According to the present disclosure, the London equations may provide microscopic relation between standing wave electrons and the vector potential, without requiring the rigidity of the many-body wave function.

One can start with the single standing wave electron function:

$$\phi_\alpha(\mathbf{r},t) = \frac{1}{\sqrt{2}}\varphi(\mathbf{r})\left(e^{i\alpha(\mathbf{r})} + e^{-i\alpha(\mathbf{r})}\right)e^{\frac{i}{\hbar}\varepsilon t} \tag{14}$$

and utilize the calculation below, while not requiring pairing, to derive the London equations. Since electron pairs are generally favored energetically, as appears from the diagonalized Hamiltonian $H_0$, a single pair wave function can be obtained. This can preserve the 2e charge observed experimentally. The superconducting standing wave states at T=0, provided by an electron pair thus provides:

$$\psi(\mathbf{r}_1,\mathbf{r}_2,t) = C\phi(\mathbf{r}_1,t)\phi(\mathbf{r}_2,t)\left|\uparrow\downarrow\right\rangle \tag{15}$$

where C is any complex constant, $\left|\uparrow\downarrow\right\rangle$ denotes a singlet state, and $\phi(\mathbf{r},t)$ is a standing wave function given by equation (14). The spatial part of $\phi(\mathbf{r},t)$ is a real function with respect to a vector potential in the London Gauge, i.e., assuming $\nabla \cdot \mathbf{A} = 0$, $\mathbf{A}\perp = 0$ at the surface of an isolated body. The corresponding probability current is:

$$\mathbf{J}(\mathbf{r},t) = \text{Re}\left[\psi^*\left(\frac{\hbar}{im}\nabla - \frac{q}{mc}\mathbf{A}\right)\psi\right] \tag{16}$$

where $J(r,t)$ is the current density as a function of location ($r$) and time ($t$), Re states that the real part of the formula is considered, $\Psi$ and $\Psi^*$ are the electron pair wave function and its conjugate, $m$ is the electron mass, $q$ if the electron charge, $\hbar$ is Planck's constant divided by $2\pi$, and $i=$square root of (-1). Equation (16) can be expanded to provide:

$$\psi^*\frac{\hbar}{im}\nabla\psi = CC^*\frac{\hbar}{im}\phi(\mathbf{r}_1,t)\phi(\mathbf{r}_2,t)\left[\nabla_1\phi(r_1,t)\phi(r_2,t) + \phi(r_1,t)\nabla_2\phi(r_2,t)\right] \tag{17}$$

such that

$$\text{Re}\left[\psi^*\frac{\hbar}{im}\nabla\psi\right] = 0 \tag{18}$$

and

$$\mathbf{J}(\mathbf{r},t) = -\frac{q}{mc}\mathbf{A}\left|\psi\right|^2 \tag{19}$$

The above provides that London equations appear as a single particle microscopic property. It is a linear relation between the probability current of each superconducting pair and the vector potential. Thus, all electron pairs obey the London equations individually. The total current is given by a summation over these states. Therefore, the relation between the total electric current and the vector potential is given by the well-known non-local Pippard integral, giving the macroscopic London equations. Additionally, it should be noted that derivation of the London equations requires no assumption on macroscopic coherence of any kind. It should also be noted that the same derivation applies to a single standing wave electron. The pairing is not required to derive the London relation, it is a result (by means of ρ2) of the same standing wave assumption.

The Pipard integral now appears as a summation over standing wave states. A summation carried over the single electron probability currents to get the total current. Therefore, the coherence length is the reciprocal of the k-state summation appearing in ρ2 giving the non-local length scale over which the relation between the current and the vector potential is maintained. Due to Pippard, the coherence length gives an estimation of the critical temperature. Therefore, the k-space extension of the flat band region at the Fermi level gives an estimate of the critical temperature. A more accurate estimation of the critical temperature will be given by estimating the low dispersive volume in k-space at the proximity of the Fermi level. This will determine the parameter ρ2 and therefore Δ and therefore Tc.

As additional potentials should be related to the London potential by a gauge transformation: $\mathbf{A'} = \mathbf{A} + \nabla\chi$, where $\chi(\mathbf{r})$ may be any scalar function. The corresponding transformation of the wave function is then:

$$\psi' = \psi e^{i\frac{q}{\hbar c}\chi(\mathbf{r})} \tag{20}$$

and the current density is

$$\mathbf{J}(\mathbf{r},t) = \mathrm{Re}\left[\psi^{*}(\mathbf{r},t)\left(\frac{\hbar}{im}\nabla - \frac{q}{mc}\mathbf{A'}(\mathbf{r},t)\right)\psi'(\mathbf{r},t)\right]$$

$$= \frac{q}{mc}\nabla\chi(r)\left|\psi'\right|^{2} - \frac{q}{mc}\nabla\chi(r)\left|\psi'\right|^{2} - \frac{q}{mc}\mathbf{A}(r,t)\left|\psi'\right|^{2} \tag{21}$$

providing again:

$$\mathbf{J}(\mathbf{r},t) = -\frac{q}{mc}\mathbf{A}(\mathbf{r},t)\left|\psi\right|^{2} \tag{22}$$

Thus, the present disclosure provides that the rigidity of the many-body wave function, which is maintained by the energy gap according to the BCS treatment, is replaced by a single-body relation that is the property of any real wave function in the London gauge. Thus, the long range coherence, explained as the phase rigidity of the order parameter, can now be understood as merely reflecting this single-electron behavior.

Without wishing to be bound by theory, it is believed that the standing waves theory provides a simple understanding of the gauge symmetry breaking observed in superconductors. This broken symmetry may arise from breaking of the periodic boundary conditions for the electronic wave function in the normal state, allowing for arbitrary phase of the wave function. The standing wave boundary condition is generally driven from the bulk, by the relaxation of the phonon cloud (or other boson for that matter) against a standing electronic wave function (eq. 3-8). This is the proposed physical understanding of gauge symmetry breaking in the case of superconductivity. Grain boundaries and other defects may only assist superconductivity by supporting these standing wave states.

The single electronic current in the standing waves treatment is not divergence free and can be described as:

$$\nabla \cdot J(r,t) = -\frac{q}{mc}A(r,t)\cdot\nabla\left|\psi(r,t)\right|^{2} \tag{23}$$

being in accordance with a BCS-like ground state where standing wave pair states are constantly created and destroyed. Again, $J(r,t)$ here is the probability current of a single pair, while the total current is assumed to provide:

$$\nabla \cdot J_{total} + \frac{d\rho}{dt} = 0 \tag{24}$$

Utilizing again the assumption of zero dispersion:

$$\frac{d\rho}{dt} = \frac{d}{dt}\sum_q \rho_q = \frac{d}{dt}\sum_{k,q} c^+_{k+q}(t)c_k(t) = \frac{d}{dt}\sum_{k,q} c^+_{k+q} e^{\frac{-i}{\hbar}\varepsilon_0 t} c_k e^{\frac{i}{\hbar}\varepsilon_0 t} = 0$$

(25)

provides that the total current in an isolated body is divergence-free.

From equation (23), it is shown that in a superconductor, the surface current should be divergence free, requiring that the wave function $\nabla|\psi(r,t)|=0$ is null at the surface of the superconductor (in the London gauge).

The understanding of the present disclosure may also be derived from the quasi-classical point of view. In the quasi-classical picture, a standing wave is a wave-packet with group velocity $v_g = 0$. The magnetic force acting on such wave-packet is $\mathbf{F} = \mathbf{v}_g \times \mathbf{B} = 0$. Therefore, the semi-classical standing wave state is not affected by magnetic fields. However, it is known that vector potential acting of the wave-packet affects the phase of the single electron wave function as shown by the Aharonov-Bohm effect. A super-current phenomenon is therefore a current of all the super-electrons as appropriate wave-packets, acting not as a collective effect due to coherence of the many-body wave function, but simply as a phase current. Such super-current, therefore, does not interfere with the electron-phonon relaxation, being a uniform current for all super-electrons.

The Pipard integral comes from the relation between the vector potential and the macroscopic current. In order to get the macroscopic current, one needs to integrate over all the standing wave k-states. This is affecting real space integration over a region on the order of the coherence length.

As a result of the above understanding, the present disclosure provides a general rule which can identify new and improved superconducting materials. This is generally similar to the Wilson's rule for metals and insulators. According to Wilson, a simple rule differentiates between insulating and conducting material by locating the Fermi level with respect to the energetic band structure of the material. If the Fermi level cuts the energy band, the material is a metal; if it falls in the gap, the material is an insulator. Additionally, if the gap is on the order of the thermal energy, the material is a semiconductor.

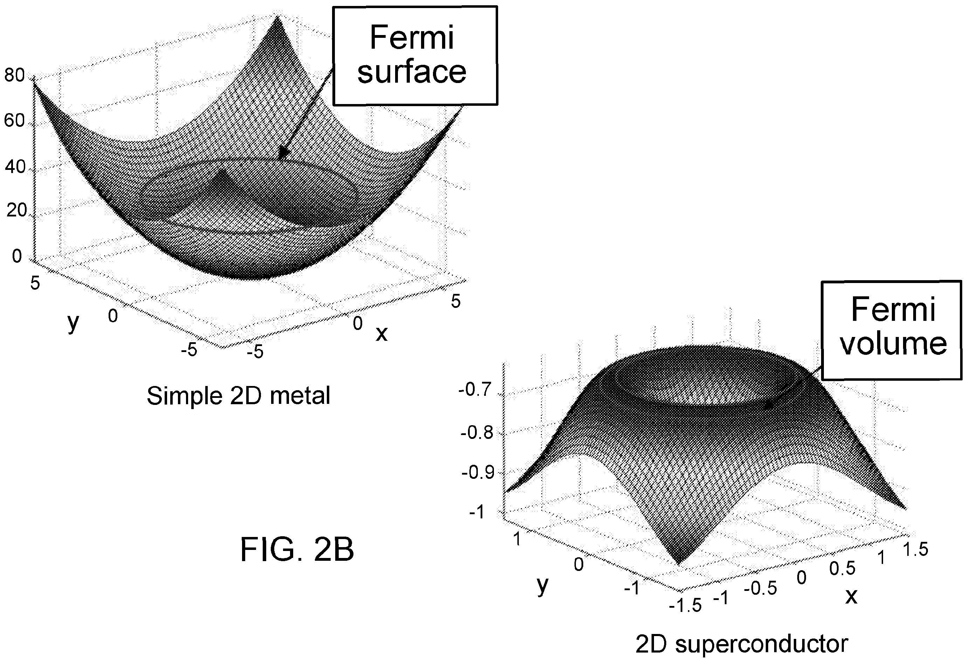

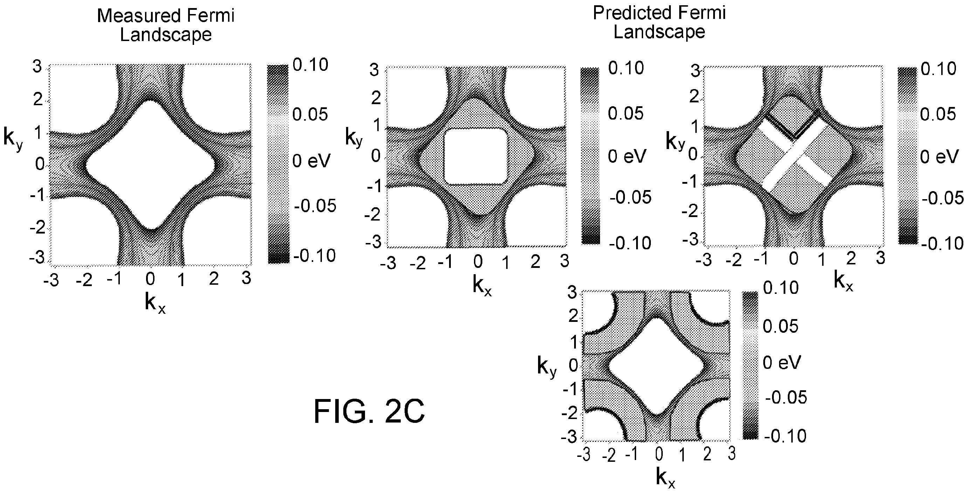

Based on the above understanding, the present disclosure provides the general principle that a superconductor behaves as a metal where the Fermi level is in the proximity (e.g., at most 50 meV) of a very shallow region of the energy levels $\varepsilon(\boldsymbol{k})$. This condition complies with the above treatment of the kinetic energy term in equation (9) as a perturbation. Additionally, this allows for the above diagonalization of the Hamiltonian $H_0$. FIG. 2 illustrates schematically the relationship among the energy band of a material, its Fermi level and its corresponding conductance according to the Wilson rule and the present disclosure.

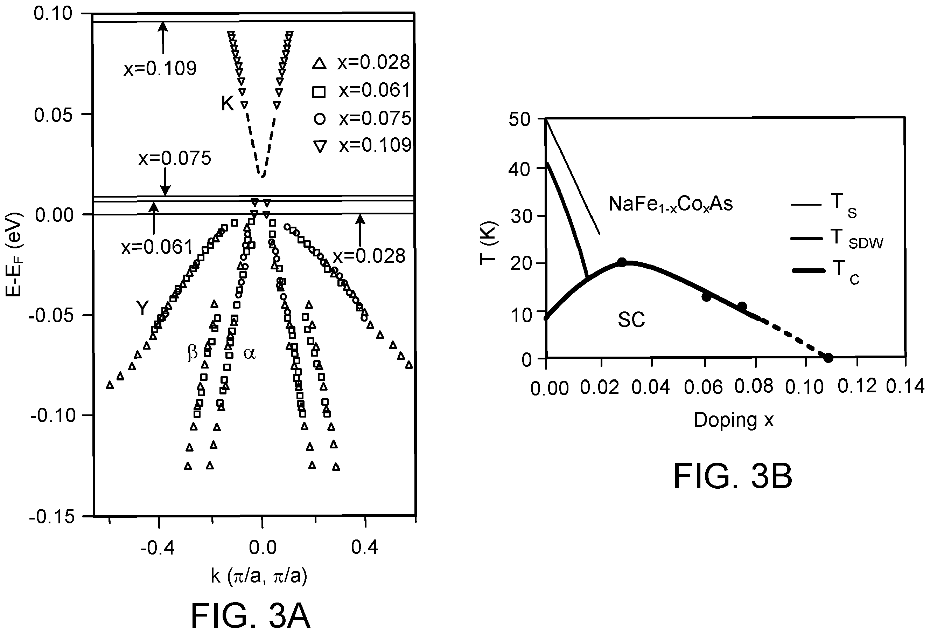

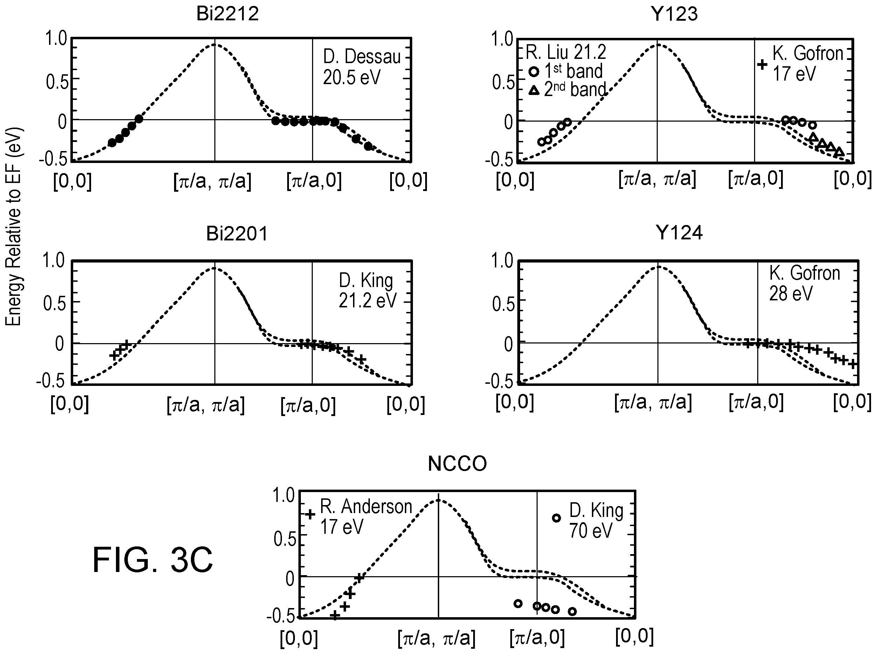

According to the above understanding, the critical temperature for superconducting effects (Tc) is believed to be determined by the size of the component $\rho_2(q)$ and therefore by the extension in k-space of the low dispersion region $\varepsilon(\mathbf{k})$. Equation (5) determines $\rho_2(q)$ as a three dimensional sum in k-space over states that are relevant to the treatment of equations (1) to (13). These are the k states that can be described in the normal state as perturbed standing wave states. These states constitute the low dispersion region $\varepsilon(\mathbf{k})$. This is consistent with measurements performed on known superconductors by ARPES showing extended low dispersion region at the proximity of the Fermi level, as can be seen in FIGs. 3a and 3b, which show known measured electronic structure results.

Thus, the general principle above can identify new materials that can act as superconductors in wide range of temperature, which can be higher than the currently available superconducting materials.

Additionally, the general principle of the present disclosure provides certain superconducting materials capable of exhibiting superconductive behavior with critical temperature higher than the currently known materials. For example, certain superconducting materials described herein may provide Tc higher than 150K, higher than 200K, higher than 250K, higher than 273K, and at about room temperature (about 300K).

As shown in equation (8) and (10) above, the energy gain in the superconducting state may be determined by the third term in the right hand side of equation (8). The critical temperature is determined by that energy gain. With all other terms varying slowly among materials of the same chemical family, the energy gain depends highly on the square density term $\rho_2(q)$ as defined in equation (5). The magnitude of $\rho_2(q)$ is determined by the extension in k-space of the nearly flat band. As an example, Fig. 3b shows the results of angular resolved photoemission measurements on several members of the cuprate family. As seen in the figure, the nearly flat region covers about one third of the Brillouin zone. This region can be increased. Thus, according to the present disclosure, the critical temperature may be increased by replacing buffer ions within the cuprate structure (e.g., Bi2212 or YBCO) with alkali ions. These buffer ions control the dispersion $\varepsilon(\mathbf{k})$ as can be seen below.

More specifically, the technique of the present disclosure utilizes cluster calculations for design of superconducting materials as shown in FIG. 1. In all superconductors synthesized to date with critical temperatures above the boiling point of liquid nitrogen (77K), at least one of the metal ions 11, 12, 13, and 14 in FIG. 1 is copper, and anions 21, 22, 23, and 24 in FIG. 1 are all oxygen. It should be noted that the present invention includes other ionic species in the plane defined by metal ions 11, 12, 13, and 14 and anions 21, 22, 23, and 24. In some examples, one or more of anions 21, 22, 23, and 24 can be other group VI elements (e.g., sulfur S, selenium Se, or tellurium Te) or group V elements (pnictogens) (e.g., nitrogen N, phosphor P, or arsenide As). It is believed that the reason to include such elements is the ability to use their p-orbitals to create a nearly bonding MO (Molecular Orbital) as explained below. It is believed that one can use these nearly bonding MOs to create the nearly flat electronic band necessary for superconductivity as explained above.

According to the present disclosure, accurate electronic state energy calculations can be performed for the octahedral structure shown in FIG. 1, which is representative of the material to be synthesized. These calculations are repeated at several representative values of the distances 34 and 35 between metal ions 31 and 32 and the plane. These values are chosen to fall in the range expected for the actual layered material, and in any case are between half the ionic radius of metal ion 31 and twice the ionic radius of metal ion 31 for distance 34, and between half the ionic radius of metal ion 32 and twice the ionic radius of metal ion 32 for distance 35. If metal ions 31 and 32 are identical, distances 34 and 35 typically are equal in each electronic state calculation. One criterion for superconductivity is that at least two of the electronic states of the octahedral structure, typically the ground state and the first excited state, are close enough in energy at some of the values of distances 34 and 35, to produce nearly flat dispersion as explained above. It should also be noted that considering the structure of the highest occupied molecular orbitals is of no less importance, as explained above.

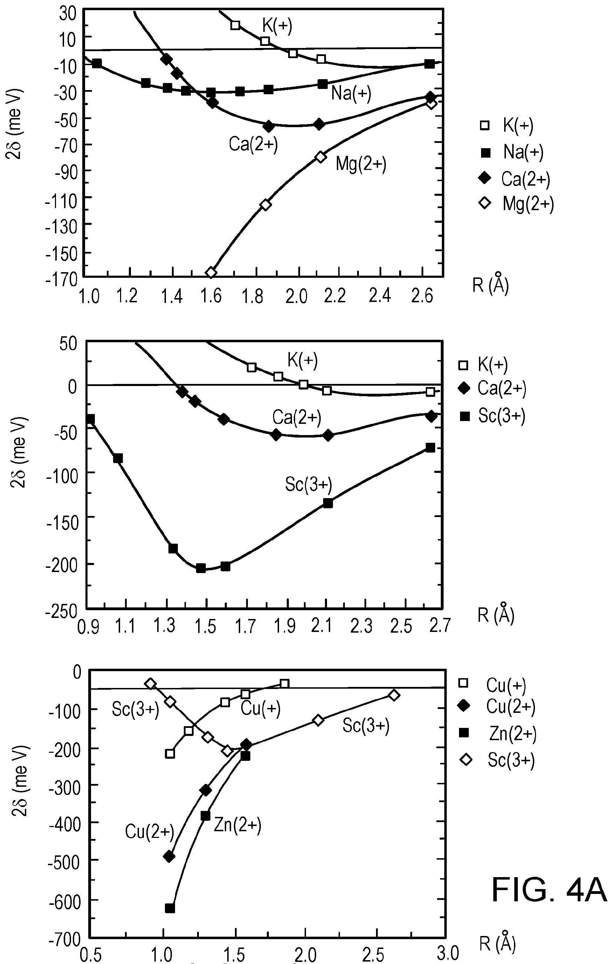

If the octahedral structure satisfies the superconductivity criterion of near degeneracy (e.g., at most 50 meV between the ground state of the cluster and the first excited state) and the proximity (e.g., at most 50 meV) between the Fermi level and the corresponding energy band, the corresponding material is to be synthesized (e.g., by using the methods described herein). Without wishing to be bound by theory, the inventor believes that the results of these calculations show several clear trends for the cuprates as seen in Fig. 4a. The data shown in Fig. 4a are collected from Panas et al., Chem. Phys. Lett, 259, 247. The most important of which is the effect of the ionic charge of the buffer ion. The lower the charge, the lower the overlap and therefore the dispersion of the narrow band. Another trend, of lower influence is the ionic radius of the buffer ion. The higher the ionic radius, the lower the overlap. The results of the quantum chemistry calculations are reproduced in figure 4a. These results, where pertaining to the component $\rho_2(q)$, provide clear synthesis routes. For example, as described above, using a precursor with an excess amount of alkaline ions and performing ion exchange proved to be efficient for inducing room temperature superconductivity. In some examples, oxides and nitrates can be used as precursors. In some examples, when using precursors containing group VI anions other than oxygen, the corresponding chalcogenides can be used. In some examples, an additional step of heating the sintered mixture in an oxygen atmosphere is needed to provide interstitial oxygen for hole doping. In some examples, when the high temperature superconductors contain mercury or thallium, they may require special treatment to be synthesized as known in the art. Superconductors can be synthesized by laser beam ablation, sputtering, molecular beam epitaxy or other methods known in the art including thin film methods. In some examples, artificial structures (superlattices) containing the above cluster and required charge reservoir layer or doping source can be obtained by the synthesis methods described herein.

Based on the above principle and model, the present disclosure provides the general requirements for identifying high temperature superconductors as follows: (1) the dispersion region of $\varepsilon$(k) at the proximity of the Fermi level is to be low (e.g., less than 50 meV), i.e. the energy differences between states in the cluster, should be as small as possible; (2) the states of this low dispersion regions should preferably be coupled to phonons (or other bosons); and (3) these electronic states should be itinerant. It should be noted that surface states or localized states can produce similar effects and appear non-dispersive in ARPES spectra while having no, or limited, contribution to superconductivity. In addition, a dispersive band, such as the Cu-O sigma band in the cuprates, supplies the screening of the coulombic potential $v(q)$ in equation (1). [Deutscher et al., Chinese Journal of Physics, 31, 805, (1993)].

Thus, the present disclosure provides methods for identifying novel superconducting materials based on the following steps: (1) locating the frontier molecular orbitals which are almost non-bonding, which may be achieved by separating the anion atom centers by a proper distance (e.g. 3.8-4.2 Å in cuprate compounds) and the molecular orbital composed of p-orbitals which generally extend in space in the plane; and (2) locating the frontier orbitals coupled to the vibrations of a close-by metal ion approximate to the plane. At this point, the ionic charge of the metal ion approximate to the plane is preferably selected such that the energy difference between the bonding and anti-bonding levels of the frontier orbitals is minimized. It is believed that this energy difference determines the dispersion of the very narrow band. Based on appropriate cluster calculations, the ionic charge of the metal ions approximate to the plane is preferably as small as possible. For example, in cuprate compounds (i.e., copper oxides), the preferred ionic charge for the metal ions approximate to the plane is +1 or lower. In addition to the ionic charge, it is believed that the radius of the metal ion approximate to the plane in cuprate-based materials is preferably to be the high (such as the radius of K, Rb, or Cs). This can reduce the bonding-anti-bonding energy level separation. This energy separation determines the narrow band dispersion and therefore the size of the component $\rho_2(q)$. The size of the component $\rho_2(q)$ Determines Tc.

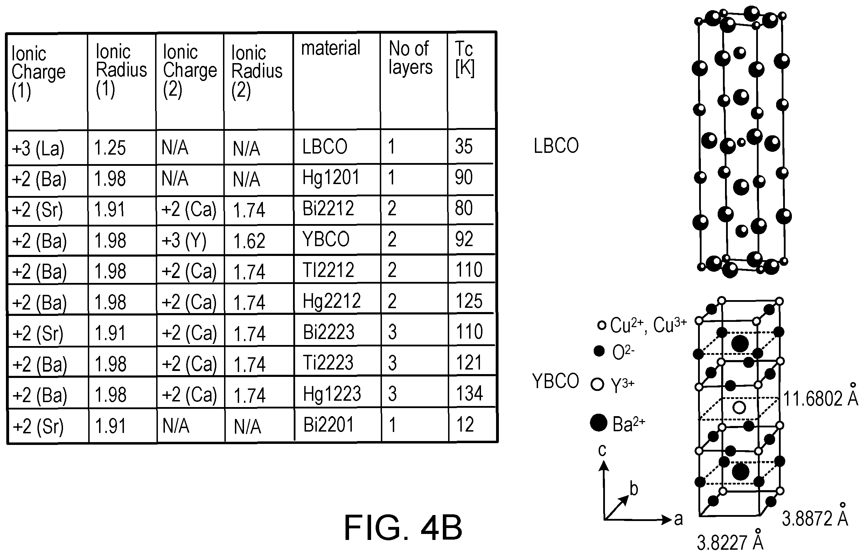

The table in Fig. 4b lists well known representatives of HTS materials. Column 1 lists the ionic charge of ions at the B site (i.e., the site corresponding to B in formula (I)). Column 2 lists the ionic radius of ions at the B site. Column 3 lists the ionic charge of ions at the Z site (i.e., the site corresponding to Z in formula (I)). Column 4 lists the ionic radius of ions at the Z site. Column 5 is the well-known name of the compound. Column 6 shows the number of $CuO_2$ layers in the compound. Column 7 lists the Tc of the different compounds. The model described above can explain qualitatively the variety of Tc in these compounds by means of the effect of the ionic charge and the ionic radius on $\rho_2(q)$ as follows. The last compound is an exception to the rule, to be dealt with at the end of this paragraph. The effect of the number of $CuO_2$ layers is clear. Increased number of layers increases $\rho_2(q)$ by introducing more k-states into the sum (equation 5). This works well as long as the doping mechanism is effective. Increasing the number of $CuO_2$ layers also increases the distance to the charge reservoir layers. The optimum is found for three layers. Therefore a good comparison will be for compounds of the same number of layers. The first two rows of the table compare the single layer compounds LBCO and Hg1201. The ionic charge at the B site decreases from +3 for LBCO to +2 for Hg1201. The value of $2\delta$, as an estimation of the oxygen band dispersion, decreases from about 130 meV (calculated for scandium) to about 40 meV (calculated for calcium). The trend is clear and, based on the model described above, Tc increases by a factor of about 3, as this is the factor of increase in $\rho_2(q)$. The next four rows compare the double layer compounds. Going from Bi2212 to YBCO, the ion at the B position increases its radius, while the ion at the Z position increases its charge. The B position is believed to be the dominant in affecting $\rho_2(q)$. Therefore there is a net increase in Tc. However, based on the model described herein, it is believed that a further increase in Tc will be obtained by replacing the +3 ion at the Z position (Y) with a +2 ion (Ca). This is what is shown in the next two rows displaying Tl2212 and Hg1212. The advantage of the Hg compounds over the Tl compounds is due to the linear coordination of Hg that relaxes structural strains. The three layers compounds are presented next. Bi2223 has 3 layers, but a smaller ion at the B position. Therefore the increase in Tc is significant with respect to Bi2212, but not with respect to the double layer Ba compounds, Tl2212 and Hg1212. The same goes for the 3-layer Tl compound. The increase in Tc is significant with respect to the double layer compound Tl2212, but not with respect to the strain relaxed Hg2212. The last 3-layer compound Hg2223, enjoys from all the benefits and seems to have exhausted all of the benefits of having +2 ions at the B and the Z positions. The last line shows the properties of the single layer Bi2201. The relatively low Tc of this compound can be explained by the details of its Fermi surface and the Fermi landscape.

Based on the model and principles established above, the next step would be to use +1 buffer ions with large ionic radius at the B site, as demonstrated in Examples 1-8 below. The $2\delta$ value for using K+ instead of Ba++ as the buffer ion, decreases from about 40 meV to below 5 meV. Therefore, the inventor believes that such a material can have a large increase in Tc due to the large increase in $\rho_2(q)$, even larger than the 3-fold increase in Tc, observed in 1987, by going from the +3 buffer ion at the B position to the +2 buffer ion at the B position. The inventor believes that even higher Tc by going to +1 ions at the B and Z position, with a maximum Tc for a relaxed structure containing purely +1 ions with large ionic radius, such as $HgCs_2Na_2Cu_3O_{6+\delta}$ or $HgRb_2Na_2Cu_3O_{6+\delta}$.

Thus, without wishing to be bound by theory, the understanding of superconductivity above leads to the inventor's belief that certain materials can exhibit superconductive behavior at a relatively high temperature (e.g., at room temperature). For example, such materials can have a crystal structure that includes cuprate layers (i.e., copper oxide layers) having alkali metal ions located between or proximal to the layers. In some examples, the fraction of alkali metal ions can be higher than 0.1 (e.g., higher than 0.2, higher than 0.3, higher than 0.4, higher than 0.5, higher than 0.6, higher than 0.7, higher than 0.8, higher than 0.9, or higher than 0.95) of the total amount of metal ions adjacent to cuprate layers in the crystal structure of the superconductor compounds described herein.

Additionally, the technique of the present disclosure provides a material containing negative ions (e.g. F- or O-) located between at least some of the alkali metal ions and at least some of the metal oxide layers (e.g., the planes defined by anions 21-24 in FIG. 1). The negative ions provide further screening of the alkali metal ion charge and thus provide ions having effective charge below +1 (e.g., at most 0.8, at most 0.6, at most 0.5, at most 0.4, at most 0.2, at most 0.1, or 0).

In the event that there is a conflict between the present disclosure and the documents (e.g., U.S. Provisional Application No. 62/069,212 filed October 27, 2014) cited herein, the present disclosure controls.

The following examples are illustrative and not intended to be limiting.

Example 1: Synthesis of High Temperature Superconductors

As mentioned herein, the chemical compositions of the compounds described in the Examples were measured by using Energy Dispersive Spectroscopy (EDS). The Tc of the compounds described in the Examples were measured by using the four probe method in a vacuum oven [Low Level Measurements Handbook, 6th edition, Keithley].

The following three families of compounds derived from the model outlined above were synthesized and exhibited room temperature superconductivity properties: Bi2212 modified to contain K (i.e., the K family), Bi2212 modified to contain Rb (i.e., the Rb family) and Bi2212 modified to contain Cs (i.e., the Cs family).

Variety of compounds belonging to the three families above were synthesized by the following general procedure: Bi2212 was prepared as a precursor. Specifically, stoichiometric amounts of CuO, $SrCO_3$, $Bi_2O_3$ and $CaCO_3$ were

ground, pressed, and sintered at 800-820°C for 24-60 hours to prepare Bi2212 (i.e., $Bi_2Sr_2CaCu_2O_y$). The Bi2212 precursor was then mixed with a carbonate salt of an alkali metal in a weight ratio of 1:1 and sintered at 800-820°C for 60 hours. The molar ratio between the alkali metal carbonate salt and the Bi2212 precursor was 7:1 when K was used, 4:1 when Rb was used, and 3:1 when Cs was used. In some of the cases, commercial Bi2212 (Alfa Aesar, Ward Hill, MA) was used. Further, in some of the cases, the reaction was done in two stages of grinding, pressing and sintering. Specifically, the sintering in the first stage lasted for 24-60 hours and the sintering for the second stage lasted for 60-96 hours. The mixtures in most cases were grinded in a glove box filled with Ar, pressed in the glove box and then sintered at 800-820°C. Variations with respect to this generic procedure are detailed in the examples.

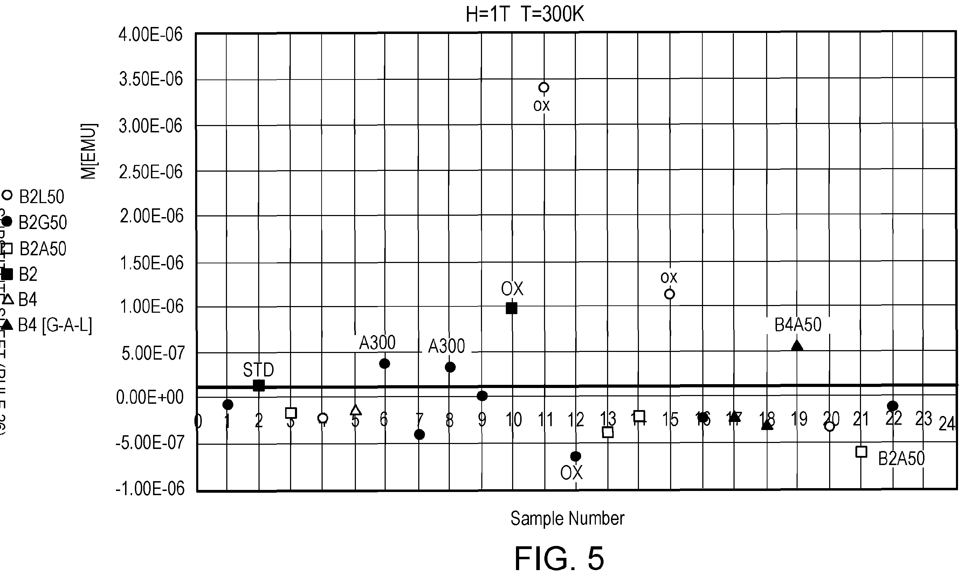

FIG. 5 presents a collection of magnetic measurements at room temperature and a field of 1 Tesla. The continuous line represents the Bi2212 precursor paramagnetic response. All of the data points below that line show different degrees of diamagnetic response. They belong to the three families of compounds described in Examples 1-6. The data points above that line were obtained by treating the three families of compounds through special treatment (high oxygen pressure, vacuum annealing, and different composition) that caused the loss of their diamagnetic response.

Example 2: Synthesis and properties of a first HTS sample in the potassium family.

A sample containing $Bi_2(K_xSr_{1-x})_2(K_tCa_{1-t})Cu_2Oy$ and $Bi_3C_m(K_xSr_{1-x})_2(K_tCa_{1-t})_2Cu_2O_y$ in the potassium family of HTS was made by the following method, which was modified based on the method described in Example 1. Bi2212 precursor was made from $Bi_2O_3$, $SrCO_3$, $CaCO_3$ and CuO, which were mixed, grinded, and sintered at 800°C. The precursor was then baked in vacuum at 400°C for 206 hours before mixing with $K_2CO_3$. The mixing at a weight ratio of 1:1 (i.e., a molar ratio between $K_2CO_3$ and Bi2212 of 7:1), grinding and pressing were done in an Ar filled glove box. The pellets were then sintered for 60 hours at 800°C to obtain a sample containing $Bi_2(K_xSr_{1-x})_2(K_tCa_{1-t})Cu_2O_y$ and $Bi_3C_m(K_xSr_{1-x})_2(K_tCa_{1-t})_2Cu_2O_y$.

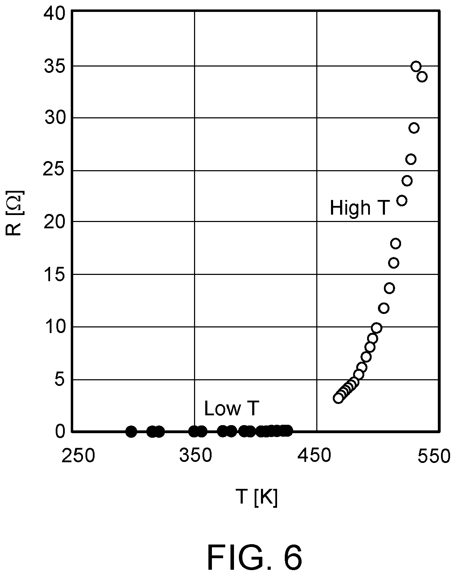

FIG. 6 shows the temperature dependence of the resistance for this sample. The electrical measurement in FIG. 6 was done by the four probe method in a vacuum oven. The graph shows a decrease of more than three orders of magnitude with decreasing temperature, typical to a superconducting transition, with a Tc onset temperature higher than 500K. The residual resistance at room temperature was 15 mΩ.

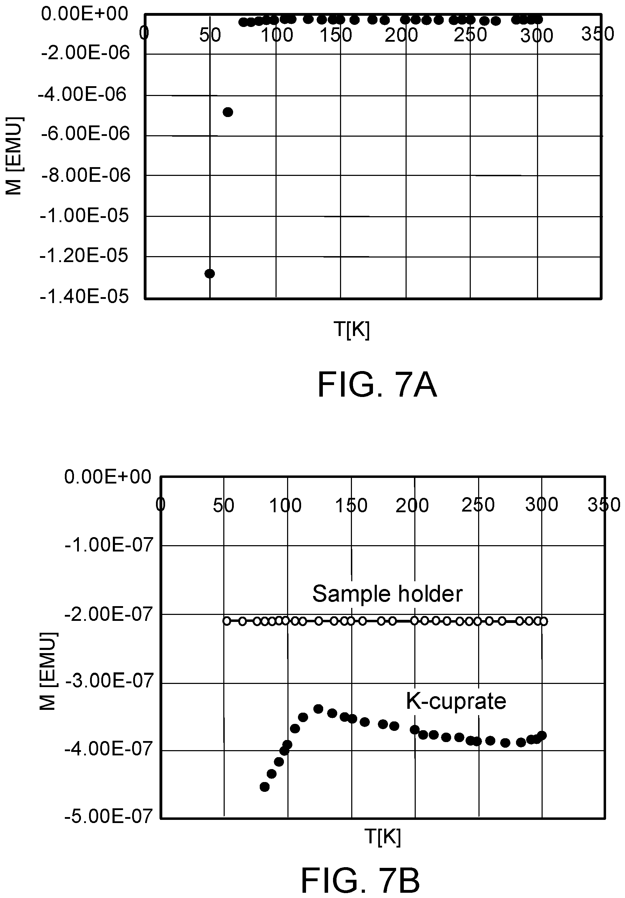

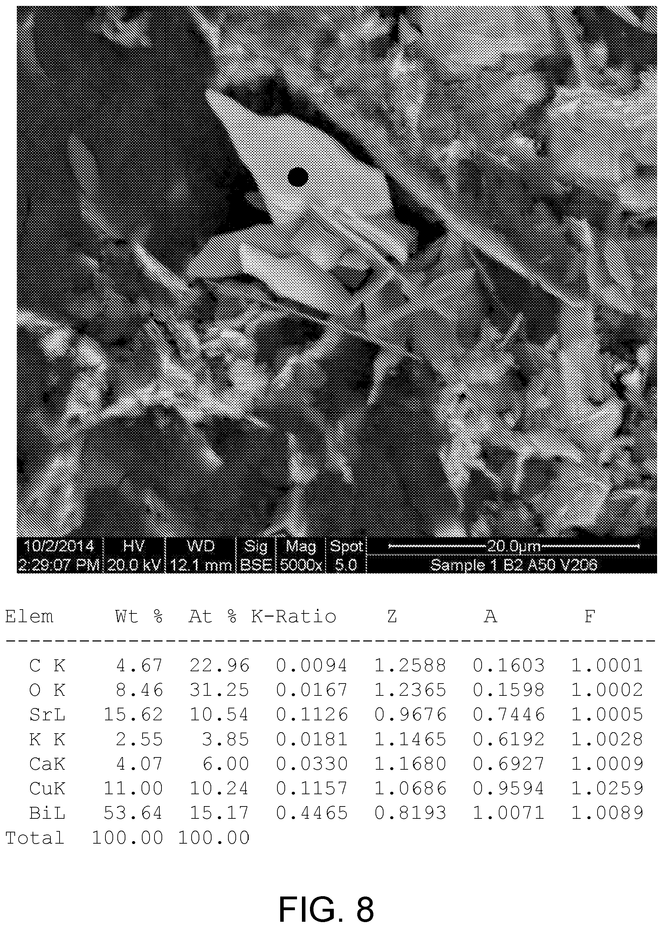

FIG. 7a shows the magnetic moment as a function of temperature from 50K to 300K for a sample of the same batch. As can be seen from this figure, the phase having a relatively low temperature Tc (i.e., about 100K) had a relatively high Meissner fraction, with a magnetic moment of -1.3E-5 EMU (1 EMU = $1 \cdot 10^{-3}$ J/T) at 50K. The phase having a Tc above room temperature had a low Meissner fraction with a magnetic moment of about -4E-7 at 300K. A similar behavior was observed in the samples in the other families. This result correlates well with EDS and XRD measurements showing a small fraction of Bi2212 with highly incorporated alkali ions, and a large fraction of Bi2212 with lightly doped alkali ions. FIG. 7b shows the same measurement from about 75K to 300K. The continuous line shows the response from the sample holder, which was used as a reference. As shown in FIG. 7b, when the temperature was increased from about 75K to 125K, it was observed that the magnetic moment increased, but remained negative and below the reference line. When the temperature was raised above 125, the magnetic moment did not become positive, as usually observed for $Bi_2Sr_2CaCu_2O_y$ (i.e., Bi2212). Instead, it remained negative, well below the reference line up to 300K. Thus, the results in FIGs. 7a and 7b suggest that a major superconducting phase having a Tc of about 100K and a minor superconducting phase having a Tc above room temperature. It is therefore believed that the major superconducting phase contained $Bi_2(K_xSr_{1-x})_2(K_tCa_{1-t})Cu_2O_y$ where each of x and t is smaller than 0.5 and the minor superconducting phase contained $Bi_3C_m(K_xSr_{1-x})_2(K_tCa_{1-t})_2Cu_2O_y$ (such as $Bi_3C_mSr_2K_{0.8}Ca_{1.2}Cu_2O_y$ as shown in FIG. 8). Other measurements showed a similar behavior of the superconducting compounds in the Rb and Cs families: a major superconducting phase at or below about 100K and a minor superconducting phase at room temperature. X-Ray Diffraction (XRD) and Energy Dispersive Spectroscopy (EDS) (see below) support this two phase picture.

FIG. 8 shows a SEM micrograph with EDS analysis of a crystallite of a new compound in the sample obtained above. This new compound belongs to the potassium family and includes a $KCaCuO_4$ cluster. Measurements were done on Environmental Scanning Electron Microscope (ESEM) Quanta 200 (FEI). The system includes an EDS system for quantitative analysis of the various elements present in the sample. The electron beam was focused at the red spot. The table in the figure shows the atomic fraction and the weight fraction of the different elements obtained from the EDS analysis. The results show that the atomic ratio of K increased from 0% to about 3.85%, indicating K was incorporated into the crystal lattice. The atomic fractions suggest the following formula: $Bi_3C_mSr_2K_{0.8}Ca_{1.2}Cu_2O_y$, which falls in the general formula: $Bi_3C_m(K_xSr_{1-x})_2(K_tCa_{1-t})_2Cu_2O_y$. This compound appears in a small fraction of this sample. It is believed that the incorporation of carbon in the crystal lattice allows for the high incorporation of potassium in the crystal lattice.

Example 3: Synthesis and properties of a second HTS sample in the potassium family

Another HTS sample in the potassium family was synthesized by a method similar to that described in Example 1. The precursor was mixed and grinded with $K_2CO_3$ in a $N_2$ filled glove box in a weight ratio of 1:1 (i.e., a molar ratio between $K_2CO_3$ and Bi2212 of 7:1). The mixture was pressed to pellets outside the glove box with intermediate evacuation in a desiccator. The pellets were then sintered for 60 hours at 800°C to obtain the sample.

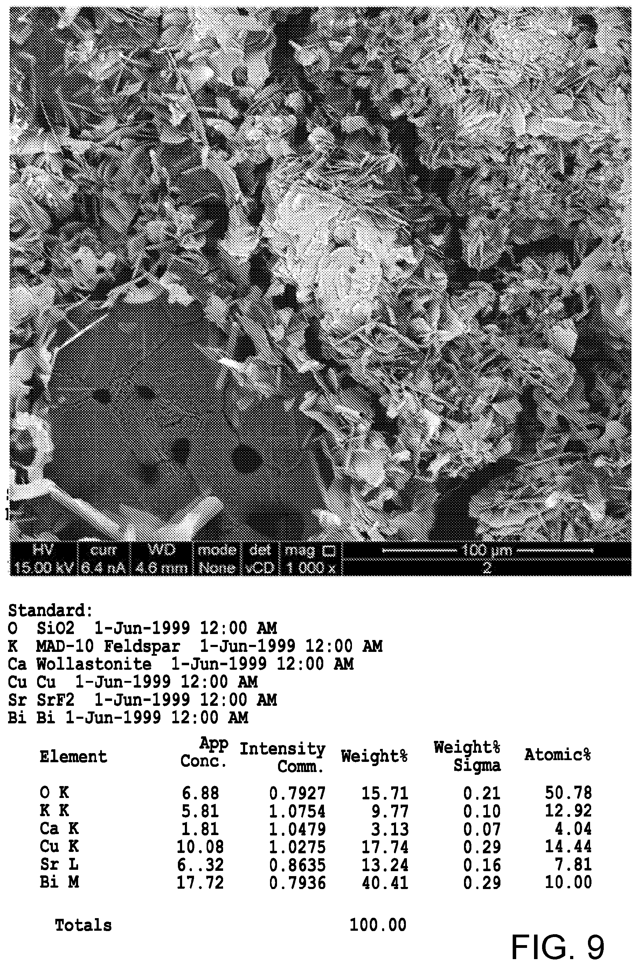

FIG. 9 shows a SEM micrograph with Energy-dispersive X-ray spectroscopy (EDS) analysis of the above sample. Measurements were done on Magellan T Extra High Resolution (XHR) SEM, equipped with a Schottky-type field emission gun. The microscope included an EDS silicon drift detector (Oxford X-Max). The electron beam was focused at the red spot. The table below the micrograph shows the atomic fraction and the weight fraction of the different elements obtained from the EDS analysis. The atomic fractions suggest a compound of the following formula: $Bi_2(K_xSr_{1-x})_4(Sr_tCa_{1-t})Cu_3O_y$, which suggests that the compound contains three copper layers. This new compound can be understood as a derivative of the superstructure Bi1212/Bi1201 with high incorporation of K. The Bi1212/Bi1201 superstructure is an intergrowth of $BiSr_2CaCu_2O_{y1}$ (Bi1212) and $BiSr_2CuO_{y2}$ (Bi1201). The results show that the atomic ratio of K increased from 0% to about 12.9%, indicating a significant K incorporation into the crystal lattice. In addition, the results show that there was a decrease in the atomic ratio of Sr from a theoretical value of about 20% (i.e., twice as Bi's atomic ratio or 4/3 of Cu's atomic ratio based on Bi1212/Bi1201) to about 7.8% and a decrease in the atomic ratio of Ca from about 5% (i.e., one third of Cu's atomic ratio or half of Bi's atomic ratio based on Bi1212/Bi1201) to about 4%, suggesting that about 65% of Sr were replaced by K (i.e., 12.9% / 20% = 0.65). Thus, Sr and K add up to a little above 20% atomic ratio as required to give $(K_xSr_{1-x})_4$, in which x is about 0.65. The extra Sr (0.8%) is believed to be incorporated on the Ca site, completing the atomic ratio at that site to about 5% as required. Looking closely at the superstructure, it is composed of the components: $Bi(K_xSr_{1-x})_2CaCu_2O_{y1}$ (Bi1212) and $Bi(K_xSr_{1-x})_2CuO_{y2}$ (Bi1201). Without wishing to be bound by theory, it is believed that one of these two components can include K with an incorporation rate of x~1. In addition, without wishing to be bound by theory, such a high value of x can explain the room temperature superconductivity observed in this sample.

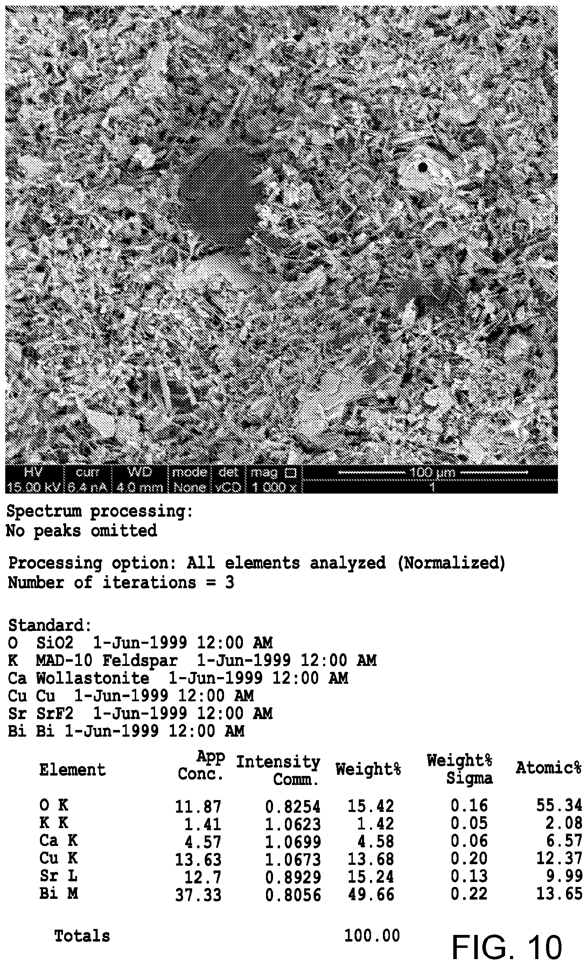

FIG. 10 shows the EDS analysis of another phase at the same sample. The electron beam was focused at the red spot. The table below the micrograph shows the atomic fraction and the weight fraction of the different elements obtained from the EDS analysis. The results show that the atomic ratio of K increased from 0% to about 2%, indicating that K was incorporated into the crystal lattice. In addition, the results show that there was a decrease in the atomic ratio of Sr from a theoretical value of about 12.4% (i.e., the same as Cu's atomic ratio) to about 10%, suggesting that about 20% of Sr was replaced by K. The results also show that there was no decrease in the atomic ratio of Ca (i.e., half of Cu's atomic ratio) to about 6.6%, suggesting that the Sr site is the preferred incorporation site for K. The above results suggest that this phase has the formula $Bi_2(K_xSr_{1-x})_2CaCu_2Oy$. A similar behavior was observed in the other examples, that is, separation to two phases. A low alkaline incorporated phase, similar to Bi2212 with x<0.5 and high alkaline incorporation phase with x>0.5. The high alkaline incorporation phase was believed to be a superstructure with or without carbon incorporation. It is believed that the superstructure facilitates the high level of alkaline incorporation and that the high alkaline incorporation phase is responsible for the room temperature superconductivity observed in these samples.

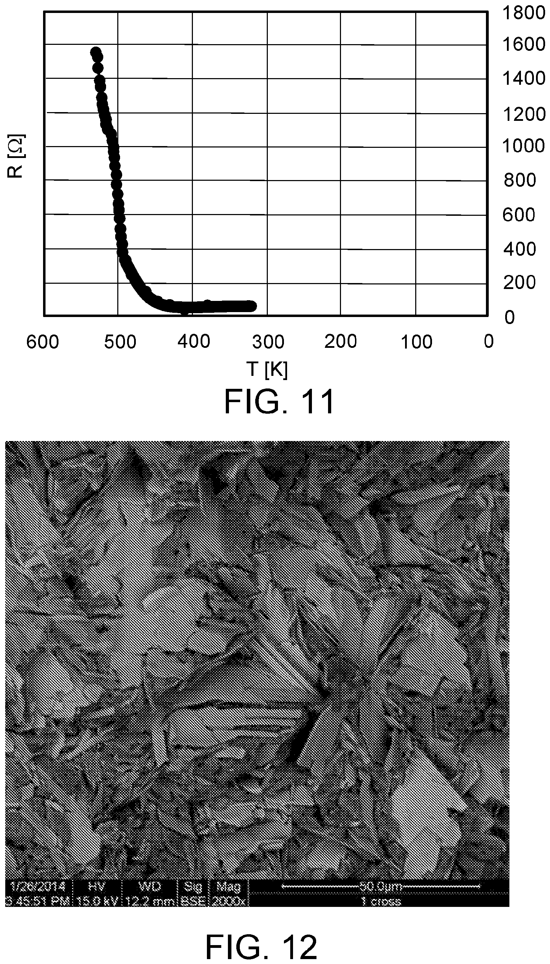

FIG. 11 shows the temperature dependent resistance of this sample. The measurement was done by the four probe method in a vacuum oven. The graph shows a decrease of more than three orders of magnitude in resistance with decreasing temperature, typical of a superconductor transition. As shown in FIG. 11, this sample has a Tc of higher than 500K. The relatively high residual resistivity is attributed to the synthesis process, producing weak links between the crystallites. The sample showed a negative magnetic moment of -2.3E-7 emu at 300K and a field of 1T.

Example 4: Synthesis and properties of a first HTS sample in the rubidium family

FIG. 12 shows the microstructure of an HTS compound belonging to the rubidium family. The sample was synthesized by the same method described in example 3, except that $K_2CO_3$ was replaced by $Rb_2CO_3$. The picture was taken by using Environmental Scanning Electron Microscope (ESEM) Quanta 200 (FEI) in the Back Scattered (BS) mode, giving contrast based on the atomic number, with higher atomic number elements appearing brighter. As shown in FIG. 12, large regions of the sample are conducting (no charging effects) with homogeneous chemistry, as can be seen from the backscattered electron image contrast. Two point resistance measurements of this compound gave values of several ohms at room temperature. In addition, FIG. 12 shows a polycrystalline material with crystallites oriented in different directions. As a result, the material exhibited a residual resistance at room temperature corresponding to the boundaries between the crystallites. EDS showed high level of rubidium incorporation in these early samples (X>0.5) with residual $Rb_2CO_3$. The EDS results suggest a compound containing three copper layers of the following formula $Bi_2C_2Sr_2Rb_{2.5}Ca_{0.64}Cu_3O_y$. Without wishing to be bound by theory, it is believed that such high value of x can explain the room temperature superconductivity observed in this sample. The residual $Rb_2CO_3$ is well seen between the crystallites and can explain the high residual resistance observed in these early samples.

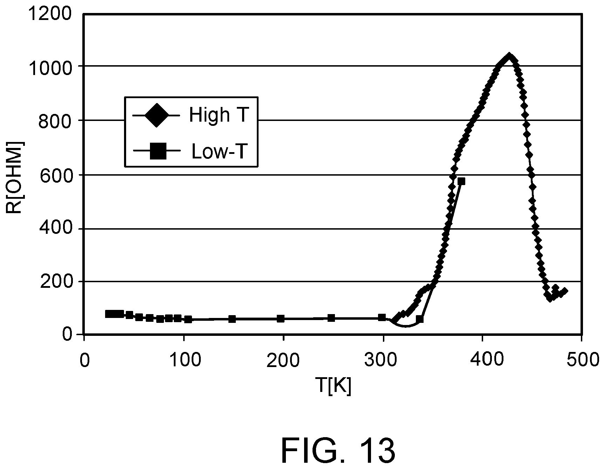

FIG. 13 shows the temperature dependence of the resistance of this sample. The resistance was measured by the four probes method. Contacts were made to the sample by using silver paste and wire bonding. The High-T curve represents high temperature measurements in a vacuum oven. The Low-T curve represents low temperature measurements in liquid helium cooled probe station. As shown in FIG. 13, this sample exhibited a superconducting transition onset at a temperature of about 400K. The resistance dropped by two orders of magnitude when the sample was cooled down to room temperature. A constant residual resistance of about 10 ohms persisted from room temperature to a temperature of 20K. This phenomenon of residual resistance is well known for polycrystalline samples as the conductivity is limited by weak links between the crystallites. According to our model, the rise in resistance when the sample was cooled from 500K to 400K is believed to be due to the opening of a semiconductor energy gap. Another example for such a rise in resistance with cooling down before the superconducting transition is in underdoped HTS Bi2201.

Example 5: Synthesis and properties of a second HTS sample in the rubidium family

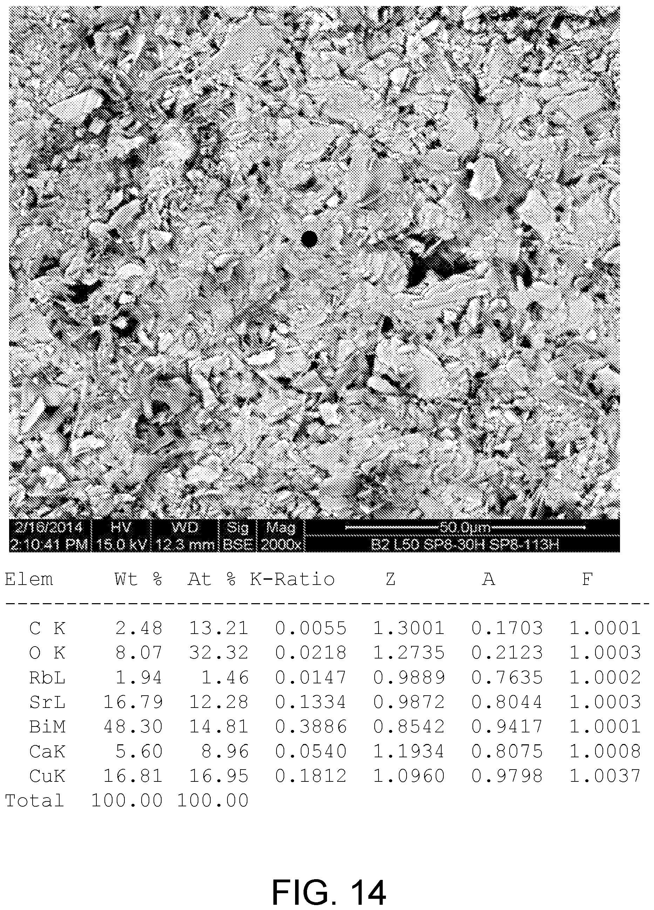

FIG. 14 shows a SEM micrograph with EDS analysis of another sample belonging to the rubidium family containing a compound of $Bi_2(Rb_xSr_{1-x})_2CaCu_2Oy$. The sample was synthesized by a similar method to the one described in Example 4 except that the ingredients were sintered first for 30 hours at 800-820°C, and followed by regrinding the product and a second sintering for 113 hours at 800-820°C. Measurements were done on Environmental Scanning Electron Microscope (ESEM) Quanta 200 (FEI). The system included an EDS system for quantitative analysis of the various elements present in the sample. The electron beam was focused at the red spot. The table in the figure shows the atomic fraction and the weight fraction of the different elements obtained from the EDS analysis. The results show that the atomic ratio of Rb increased from 0% to about 1.2%, indicating Rb was incorporated into the crystal lattice. In addition, the results show that there was a decrease in the atomic ratio of Sr from a theoretical value of about 13.5% (i.e., the same as Cu's atomic ratio) to about 9.8% and a slight increase in the atomic ratio of Ca from about 6.75% (i.e., half of Cu's atomic ratio) to about 7.9%, which may suggest a small incorporation of Ca at the Sr site. It is believed that this example had a low incorporation percentage of the alkali ion (x>0 but t=0).

Example 6: Synthesis and properties of a third HTS sample in the rubidium family

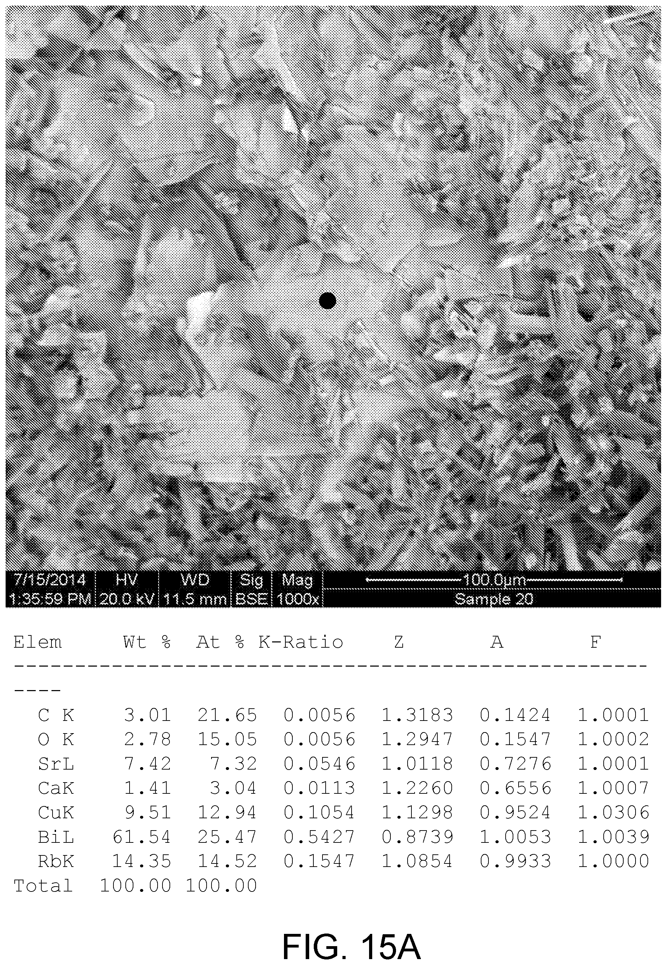

FIG. 15a shows a SEM micrograph with EDS analysis of another sample of the rubidium family. The sample was synthesized by the method of example 1. The figure shows a crystallite of a new compound belonging to the rubidium family and including the $RbCaCuO_4$ cluster or the $Rb_2CuO_4$ cluster. Measurements were done on Environmental Scanning Electron Microscope (ESEM) Quanta 200 (FEI). The system includes an EDS system for quantitative analysis of the various elements present in the sample. The electron beam was focused at the red spot. The table in the figure shows the atomic fraction and the weight fraction of the different elements obtained from the EDS analysis. The results show that the atomic ratio of Rb increased from 0% to about 20%, indicating Rb was incorporated into the crystal lattice. The atomic fractions suggest the following formula: $Bi_4C_mSrRb_{2.2}Ca_{0.5}Cu_2O_y$. As the Bi atomic fraction corresponds to 4 Bi ions per unit cell, the crystal structure of this compound is believed to be an intergrowth of two different blocks of the family $Bi_2C_mSr_2CuO_y$ (C-Bi2201/C-Bi2201) with Sr being replaced by Rb and Ca. It is believed that the ordering of the superstructure Bi2201/Bi2201 requires some clear difference between the two Bi2201 blocks. Therefore, it is believed that the EDS result may suggest that the structure of this compound is the intergrowth of the following two structures: $Bi_2C_{m1}Rb_2CuO_{y1}/ Bi_2C_{m2}SrRb_{0.2}Ca_{0.5}CuO_{y2}$. Without wishing to be bound by theory, such a high value of x can explain the room temperature superconductivity observed in this sample.

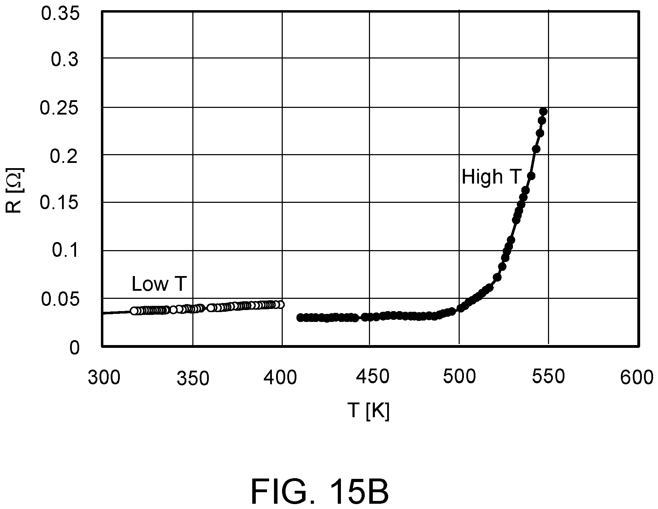

FIG. 15b shows the resistance vs. temperature graph for this sample. The measurement was done by the four probe method in a vacuum oven. This figure shows that this sample has a Tc above 550K and a residual resistance of 30 mΩ.

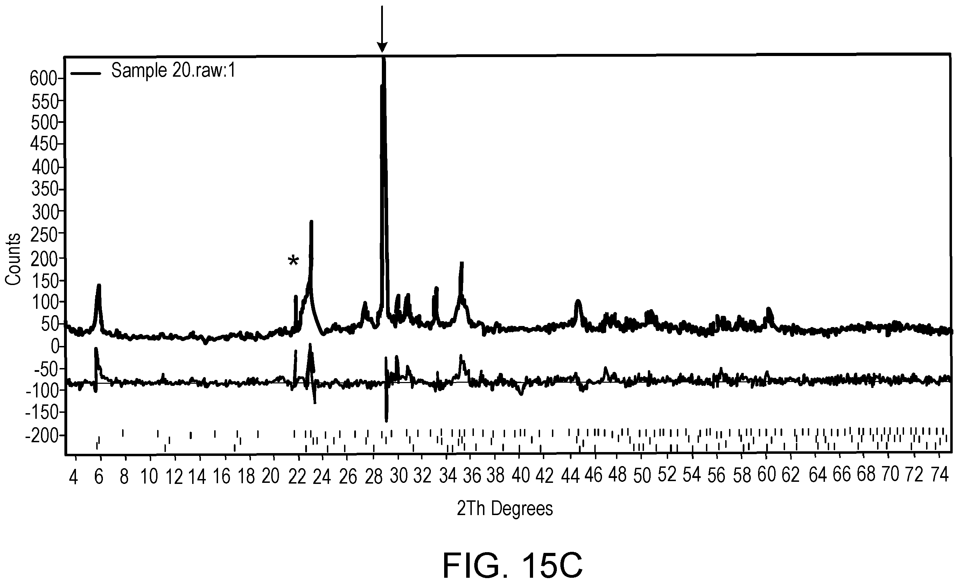

FIG. 15c shows XRD data for the rubidium HTS sample of FIG. 15a. The coarse line at the top is the raw data. The fine line at the top is the calculated curve obtained by Rietveld analysis. The coarse line at the bottom is the residual difference between the raw data and the calculated curve. The arrow shows the main peak affected by Rb incorporation. The analysis used the data obtained from the magnetic measurements and EDS that shows the existence of two different superconducting phases: a relatively low temperature superconductor assigned to the phase with little or no incorporation of Rb and a high temperature superconductor phase (with a Tc above room temperature) assigned to the phase with a high degree of Rb incorporation. The asterisk designates an unknown impurity.

Example 7: Synthesis and properties of a HTS sample in the cesium family

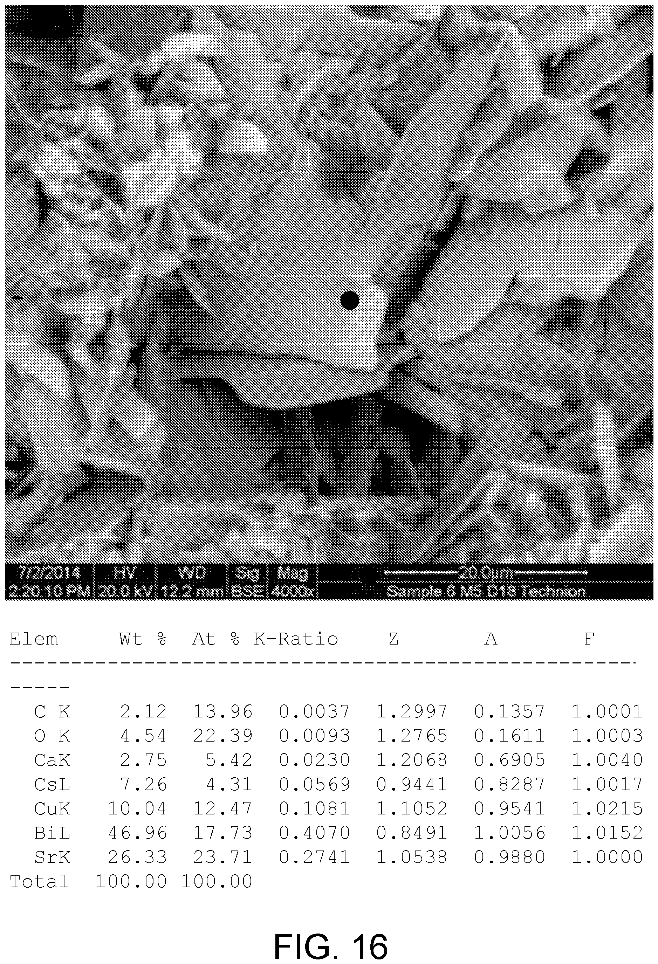

A HTS sample in the cesium family was synthesized by the method described in Example 1. Specifically, the same Bi2212 precursor was used. The precursor was mixed and grind with $Cs_2CO_3$ at a weight ratio of 1:1 (i.e., a molar ratio between $Cs_2CO_3$ and Bi2212 of 3:1) in an Ar filled glove box. The pressing was done in the glove box. FIG. 16 shows a SEM micrograph with EDS analysis of a crystallite of a new compound including the $CsCaCuO4$ cluster. Measurements were done on Environmental Scanning Electron Microscope (ESEM) Quanta 200 (FEI). The system includes an EDS system for quantitative analysis of the various elements present in the sample. The electron beam was focused at the red spot. The table in the figure shows the atomic fraction and the weight fraction of the different elements obtained from the EDS analysis. The results show that the atomic ratio of Cs increased from 0% to about 4.3%, indicating that Cs was incorporated into the crystal lattice. The atomic fractions suggest the following formula: $Bi_3C_2Sr_4Cs_{0.7}CaCu_2O_y$.

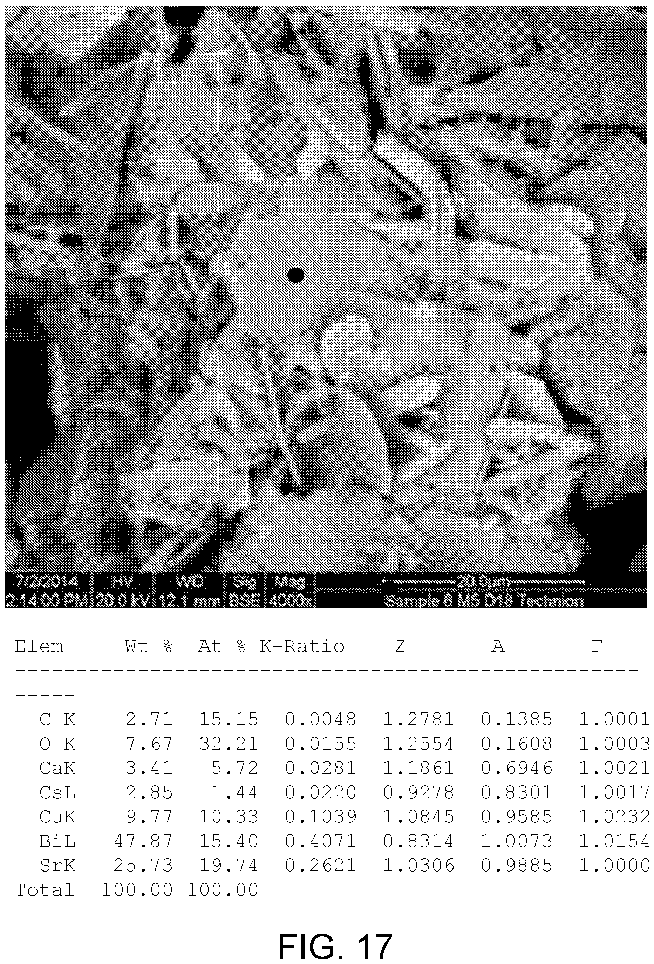

FIG. 17 shows a SEM micrograph with EDS analysis of another crystallite of the same sample. The electron beam was focused at the red spot. The table shows the atomic fraction and the weight fraction of the different elements obtained from the EDS analysis. The results show that the atomic ratio of Cs increased from 0% to about 1.5%, indicating some Cs incorporation into the crystal lattice. The atomic fractions suggest the following formula: $Bi_3C_3Sr_4Cs_{0.3}Ca_{1.1}Cu_2O_y$. In this compound, x is smaller than 0.5.

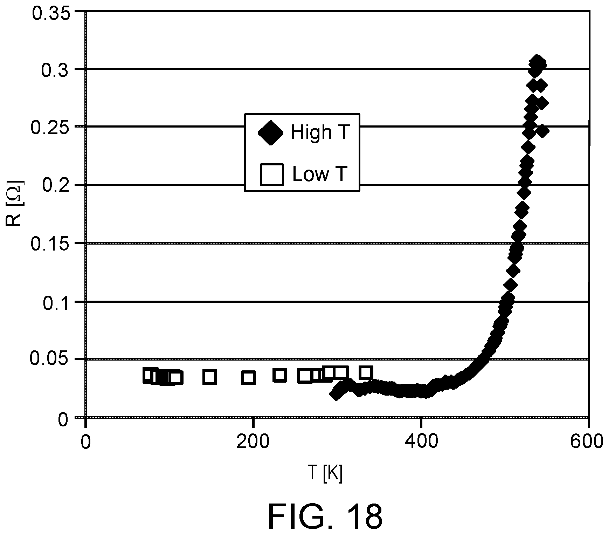

FIG. 18 shows the temperature dependence of the resistance of this sample. The high temperature measurements were done in a vacuum oven and the low temperature measurements were done in a liquid nitrogen cooled probe station. The residual resistance from room temperature to 80K was 30mΩ. Low residual resistance samples belonging to the three alkali families were obtained and their temperature dependence of the resistance was measured. Their average residual resistance from room temperature to 100K was 30-50 milli-ohms, with the lowest residual resistance being 10 milli-ohms. These values are comparable to the residual resistance measured at 20K from standard YBCO produced by the inventor.

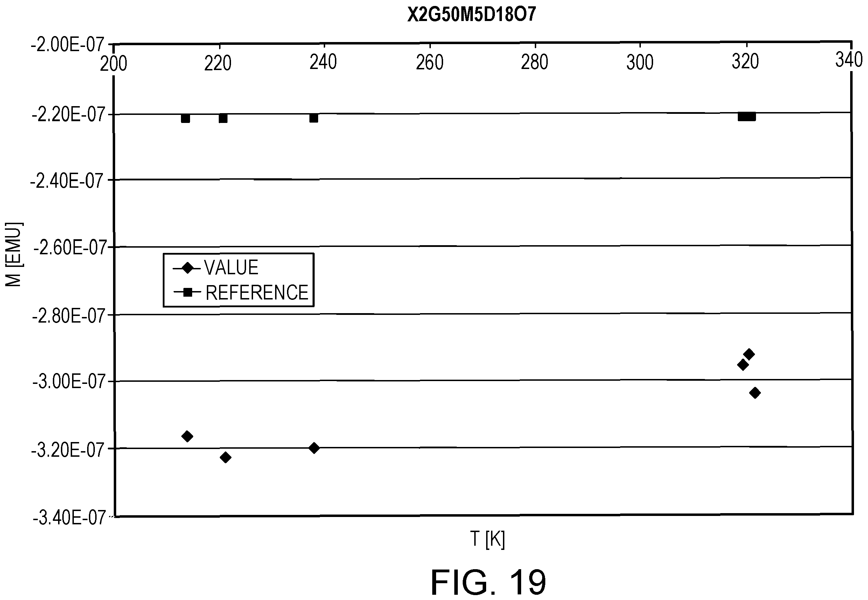

FIG. 19 shows the magnetic moment as a function of temperature for the cesium HTS sample above. The measurement was made on a commercial Cryogenic SQUID system. The sample was held in a gelatin capsule in a plastic straw. The magnetic field in this measurement was kept at 1T. As shown in FIG. 19, the magnetic moment of this compound was negative, indicating diamagnetic response. The continuous curve represents a reference response measured from the sample holder. As shown in the figure, the diamagnetic response of the cesium HTS sample was well below the reference response, indicating a true diamagnetic response.

As shown in FIG. 19, the diamagnetic response of the cesium HTS sample persisted up to a temperature of 320K, the maximum allowed temperature of the measurement system. As discussed above, the superconducting transition occurred at about 400K and therefore is not observed in FIG. 19. However, diamagnetic response of the cesium HTS sample at room temperature is apparent.

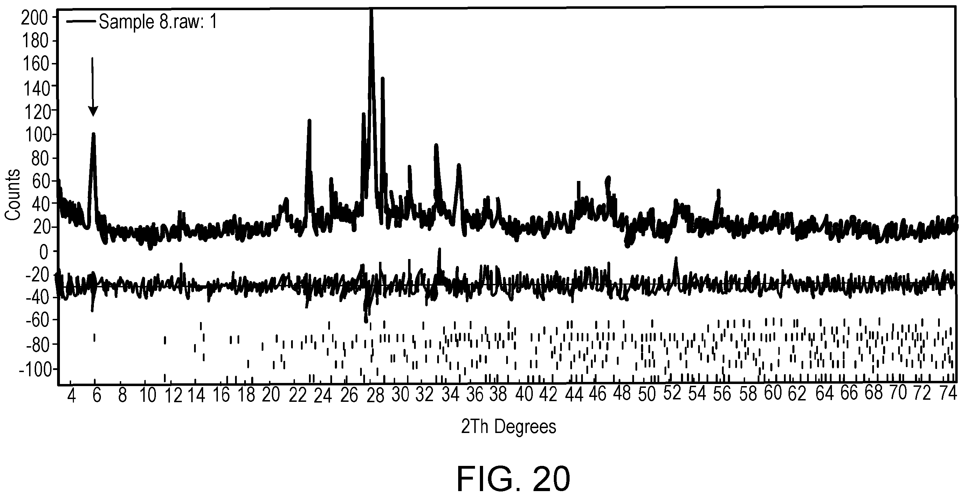

FIG. 20 shows XRD data for the cesium RTS sample. The coarse line at the top is the raw data. The fine line at the top is the calculated curve obtained by Rietveld analysis. The coarse line at the bottom is the residual difference between the raw data and the calculated curve. The arrow shows the main peak affected by Cs incorporation. The analysis used the data obtained from the magnetic measurements and EDS that shows the existence of two different superconducting phases: a low temperature superconductor assigned to the phase with little or no incorporation of Cs and a room temperature superconductor phase assigned to the phase with a high degree of Cs incorporation.

Example 8: Ion replacement: members of the rubidium and the potassium families.

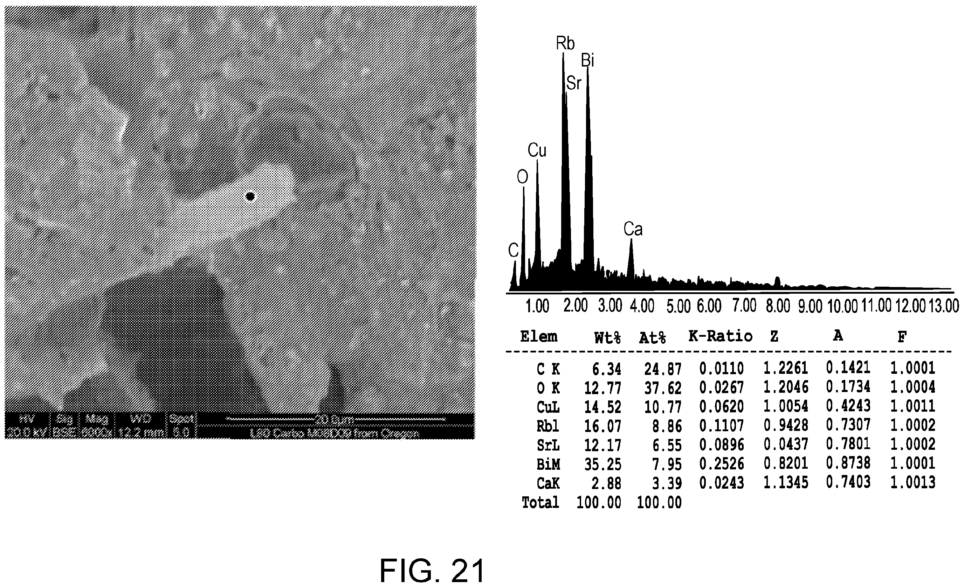

FIG. 21 shows a SEM micrograph with EDS analysis of another sample of the rubidium family. The sample was synthesized by a method similar to Example 1. The weight ratio between $Rb_2CO_3$ and the Bi2212 precursor was 8:2. The grinded mixture was heated to 750°C and dwelled there for 4-6 hours. The mixture was then heated to 810°C and sintered for 150-300 hours. The long sintering time allowed for diffusion and ion replacement of Rb for Sr. FIG. 21 shows a crystallite of a new compound belonging to the rubidium family and including the $RbCaCuO_4$ cluster or the $Rb_2CuO_4$ cluster. Measurements were done on Environmental Scanning Electron Microscope (ESEM) Quanta 200 (FEI). The system included an EDS system for quantitative analysis of the various elements present in the sample. The electron beam was focused at the black spot. The table in FIG. 21 shows the atomic fraction and the weight fraction of the different elements obtained from the EDS analysis at that spot. The results show that the atomic ratio of Rb increased from 0% to about 9%, indicating Rb was incorporated into the crystal lattice. The atomic fractions suggest the following formula: $BiC_mSr_2Rb_2CaCu_2O_y$. Therefore, the EDS results suggest x>0.5. Without wishing to be bound by theory, it is believed that such a high value of x can explain the room temperature superconductivity observed in this sample.

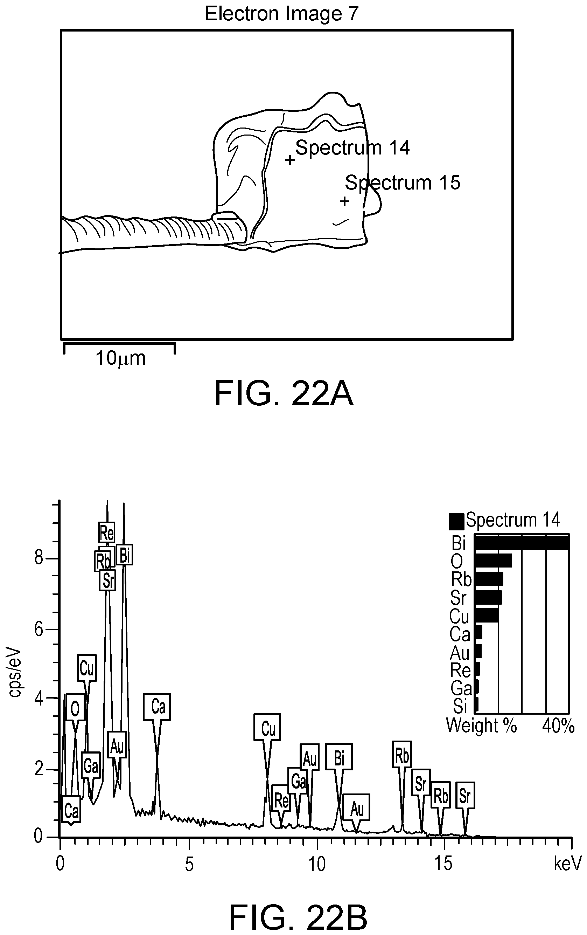

FIG. 22a shows such a crystallite hanging on a probe in an FEI Helios dual beam system. The system combined a Focused Ion Beam (FIB) with an electron beam (e-beam). The small crystal was identified by the e-beam, extracted by the FIB and the probe, cleaned with FIB on the probe, and analyzed by the e-beam and EDS. The spectrum in FIG. 22b is the result of the EDS analysis at spot number 14 shown in Fig. 22. The EDS results suggest the following general formula: $BiC_m(Rb_xSr_{1-x})_4CaCu_2O_y$. The weight fractions of Sr and Rb are almost identical, showing x~0.5. Without wishing to be bound by theory, it is believed that such a high value of x can explain the room temperature superconductivity observed in this sample.

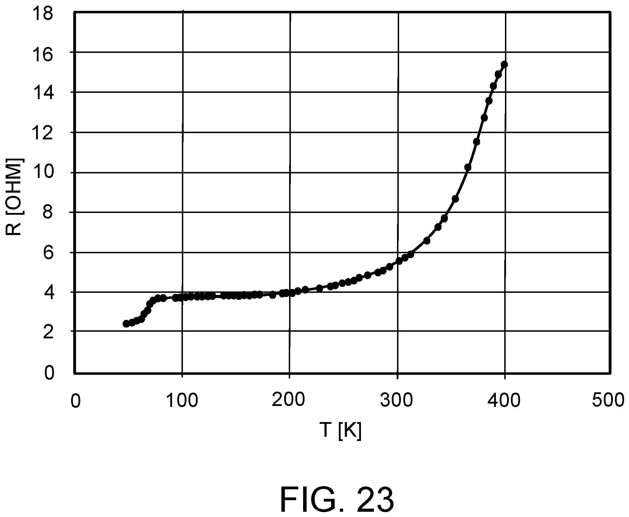

FIG. 23 shows the resistance vs. temperature graph for a sample made by the same method as the sample shown in FIG. 21. The measurement was done by the three probe method in a Quantum Design PPMS system. A transition temperature at about 80K indicates the presence of residual precursor Bi2212. FIG. 23 shows that this sample has a Tc above 350K. The residual resistance is high because of the three probe method used here.

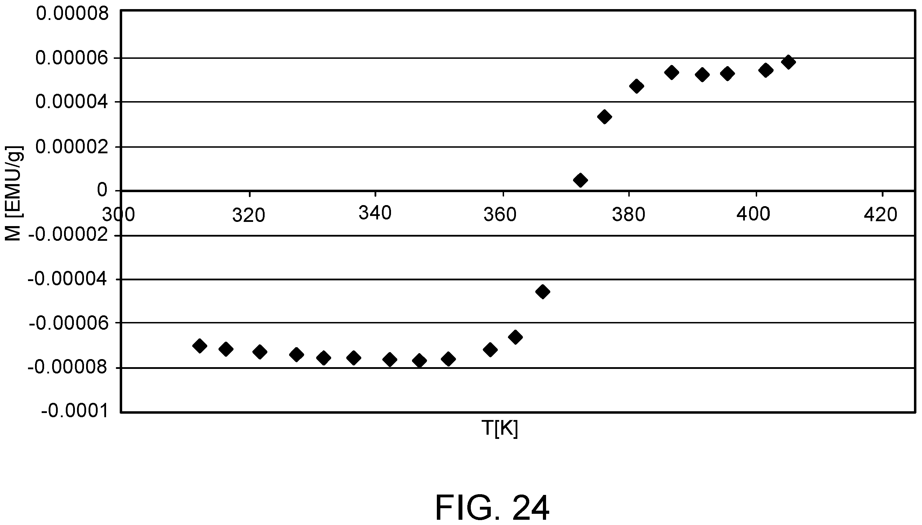

FIG. 24 shows the magnetic moment vs. temperature graph for a sample made by the same method as the sample shown in FIG. 21. As can be seen in this figure, the sample shows a diamagnetic response (negative magnetic moment) below room temperature. The magnetic moment becomes positive at a temperature (i.e., Tc) of about 370K, well above room temperature. The measurement was done on a Quantum Design MPMS system equipped with an oven for high temperature measurements.

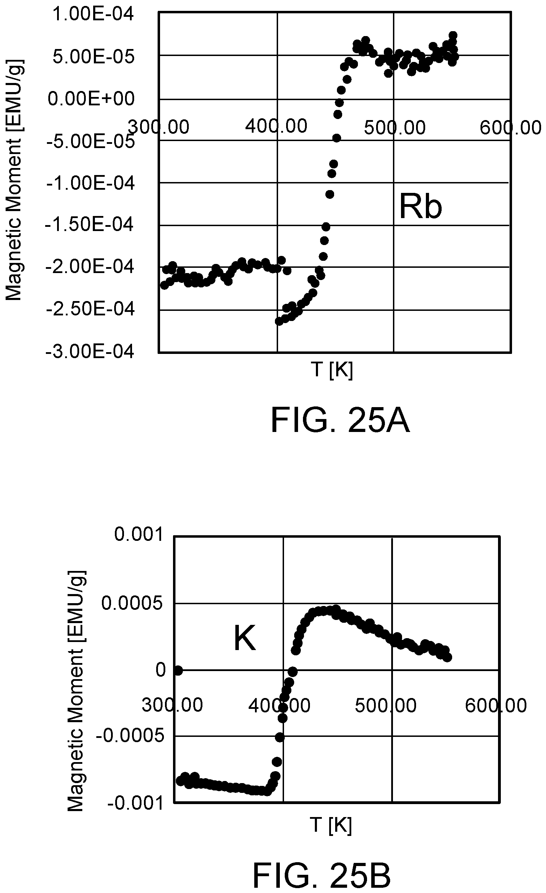

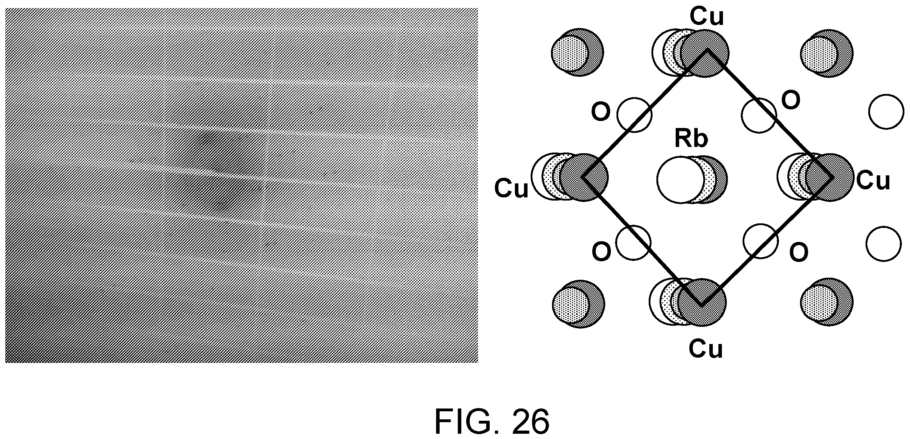

FIG. 25a shows the magnetic moment vs. temperature graph for a sample of the rubidium family, grown at the same conditions as the sample shown in FIG.21, but for a longer sintering time of 180 hours. EDS measurements on the crystals showed the atomic ratio Bi:Sr:Rb:Ca:Cu to be approximately 2:2:2:1:2. The magnetic measurement was done on the same system as the system used to obtain the results shown in FIG. 24. As can be seen in FIG. 26a, the transition is sharper, indicating a Tc of about 450K.

FIG. 25b shows the same type of magnetic measurement on a sample of the potassium family grown by the same method as the sample shown in FIG. 21, except that the weight ratio between $K_2CO_3$ and Bi2212 was 2:8 and the dwelling time at 810°C was 180 hours. EDS measurements on the crystals showed the atomic ratio Bi:Sr:K:Ca:Cu to be approximately 2:2:2:1:2. The transition here indicates a Tc of about 400K. It should be noted that such a difference in Tc between the rubidium compound and potassium compound is in accordance with the model described herein, where the larger ionic radius of rubidium creates a lower overlap between the oxygen p orbitals, measured as a lower energy difference in the calculation. Such a lower overlap creates a more shallow band at the Fermi level and therefore larger $\rho_2(q)$, which results in a higher Tc.

FIG. 26 shows the results of small crystal diffraction of a sample belonging to the rubidium family. The left panel shows one of the frames. The measurements were performed on ID29 beam of the European Synchrotron Radiation Facility (ESRF). EDS and X-Ray Fluorescence (XRF) on the small crystals showed the same composition as in FIGs 21 and 22. The right panel shows the result of refinement of the structure. The square in the middle defines the cluster described herein. Cu ions are located at the corners of the square and the oxygen ions are along the edges. The rubidium ion was found to be located just above the center of the square, replacing the Sr ion at the apex of the cluster, in accordance with the model described herein. The distances between the ions in the cluster were found to be typical of the cuprates, with the distance Cu-O being appx. 1.9 Å. The lattice parameters were found to be a=5.3880(11)Å, b=5.3760(11)Å and c=15.484(3)Å, in accordance with a strained cuprate structure. The height of the Rb ion above the $CuO_2$ plane was found to be about 2.3 Å. For such a cluster, the model described herein predicts an overlap of less than 10 meV as an estimation of the narrow band dispersion. This value should be compared with the measured value of 40 meV band dispersion in Bi2212. Without wishing to be bound by theory, it is believed that such a low value of the band dispersion gives rise to a very high $\rho_2(q)$ that can explain the room temperature superconductivity observed in this sample.

Fig. 27 shows the various crystal sizes obtained over a period of a year. The graph indicates a significant improvement in the concentration crystal size of RTS material in the samples.

Other embodiments are within the scope of the following claims.


**Claims**

1. A compound of formula (I):

$$L_nD_m(B_xB'_{1-x})_r(Z_tZ'_{1-t})_qM_pA_y \qquad (I),$$

wherein

n is a number from 0 to 3;
m is a number from 0 to 6;
x is a number from 0.4 to 1;
r is a number from 1 to 8;
t is a number from 0 to 1;
q is a number from 0 to 6;
p is a number from 1 to 7;
y is a number from 1 to 20;
L comprises Bi, Cu, or Hg;
D comprises at least one element selected from the group consisting of the elements in Groups IIIA and IVA in Periodic Table;
B comprises at least one first alkali metal ion selected from the group consisting of Na, K, Rb, and Cs;
B' comprises at least one first ion selected from the group consisting of alkaline earth metal ions and rare earth metal ions;
Z comprises at least one second alkali metal ion selected from the group consisting of Na, K, Rb, and Cs;
Z' comprises at least one second ion selected from the group consisting of alkaline earth metal ions and rare earth metal ions;
M comprises at least one transition metal ion; and
A is O;
wherein the compound is a crystalline compound.

2. The compound of claim 1, wherein D comprises C, Si, Ge, Sn, Pb, or Al.

3. The compound of claim 1, wherein B' comprises La, Mg, Ca, Sr, or Ba.

4. The compound of claim 1, wherein Z' comprises Ca or Y.

5. The compound of claim 1, wherein M comprises Cu or Fe.

6. The compound of claim 1, wherein the compound has a tetragonal or orthorhombic crystal structure.

7. A compound, wherein the compound is a crystalline metal oxide comprising at least one transition metal ion comprising Bi, Cu, or Hg and at least one alkaline earth metal ion or at least one rare earth metal ion, in which from 50% to 95% of the at least one alkaline earth metal ion or at least one rare earth metal ion is replaced by an alkali metal ion comprising Na, K, Rb, or Cs.

8. The compound of claim 7, wherein the crystalline metal oxide before from 50% to 95% of the at least one alkaline earth metal ion or the at least one rare earth metal ion is replaced by an alkali metal ion comprising Na, K, Rb, or Cs is $Bi_2Sr_2CaCu_2O_y$.

9. A method to produce a compound according to claim 1 or according to claim 7, comprising:

   mixing a crystalline metal oxide with an alkali metal salt containing an alkali metal ion to form a mixture, wherein the metal oxide comprises at least one transition metal ion and at least one alkaline earth metal ion and the atomic ratio between the alkali metal ion and the at least one alkaline earth metal ion is higher than 1:1; and sintering the mixture at an elevated temperature to form a crystalline compound containing the alkali metal ion.

10. The method of claim 9, wherein the crystalline metal oxide is $Bi_2Sr_2CaCu_2O_y$.

11. The method of claim 9, wherein from 50% to 95% of the at least one alkaline earth metal ion is replaced by the alkali metal ion.

12. The method of claim 9, wherein the atomic ratio between the alkali metal ion and the at least one alkaline earth metal ion is at least 2:1.

13. A composition, comprising the compound of claim 1.

14. The compound of claim 1, wherein the compound is $Bi_2Rb_2Sr_2CaCu_2O_y$.


**Patentansprüche**

1. Verbindung der Formel (I):

$$L_nD_m(B_xB'_{1-x})_r(Z_tZ'_{1-t})_qM_pA_y \qquad (I),$$

wobei

n für eine Zahl von 0 bis 3 steht;
m für eine Zahl von 0 bis 6 steht;
x für eine Zahl von 0,4 bis 1 steht;

r für eine Zahl von 1 bis 8 steht;
t für eine Zahl von 0 bis 1 steht;
q für eine Zahl von 0 bis 6;
p für eine Zahl von 1 bis 7 steht;
y für eine Zahl von 1 bis 20 steht;
L Bi, Cu oder Hg umfasst;
D mindestens ein Element aus der Gruppe bestehend aus den Elementen in den Gruppen IIIA und IVA im Periodensystem umfasst;
B mindestens ein erstes Alkalimetallion aus der Gruppe bestehend aus Na, K, Rb und Cs umfasst;
B' mindestens ein erstes Ion aus der Gruppe bestehend aus Erdalkalimetallionen und Seltenerdmetallionen umfasst;
Z mindestens ein zweites Alkalimetallion aus der Gruppe bestehend aus Na, K, Rb und Cs umfasst;
Z' mindestens ein zweites Ion aus der Gruppe bestehend aus Erdalkalimetallionen und Seltenerdmetallionen umfasst;
M mindestens ein Übergangsmetallion umfasst und
A für O steht;
wobei es sich bei der Verbindung um eine kristalline Verbindung handelt.

2. Verbindung nach Anspruch 1, wobei D C, Si, Ge, Sn, Pb oder Al umfasst.

3. Verbindung nach Anspruch 1, wobei B' La, Mg, Ca, Sr oder Ba umfasst.

4. Verbindung nach Anspruch 1, wobei Z' Ca oder Y umfasst.

5. Verbindung nach Anspruch 1, wobei M Cu oder Fe umfasst.

6. Verbindung nach Anspruch 1, wobei die Verbindung eine tetragonale oder orthorhombische Kristallstruktur aufweist.

7. Verbindung, wobei es sich bei der Verbindung um ein kristallines Metalloxid handelt, das mindestens ein Übergangsmetallion, das Bi, Cu oder Hg umfasst, und mindestens ein Erdalkalimetallion oder mindestens ein Seltenerdmetallion umfasst, wobei 50 % bis 95 % des mindestens einen Erdalkalimetallions oder mindestens einen Seltenerdmetallions durch ein Alkalimetallion, das Na, K, Rb oder Cs umfasst, ersetzt sind.

8. Verbindung nach Anspruch 7, wobei es sich bei dem kristallinen Metalloxid vor dem Ersatz von 50 % bis 95 % des mindestens einen Erdalkalimetallions oder des mindestens einen Seltenerdmetallions durch ein Alkalimetallion, das Na, K, Rb oder Cs umfasst, um $Bi_2Sr_2CaCu_2O_y$ handelt.

9. Verfahren zur Herstellung einer Verbindung nach Anspruch 1 oder nach Anspruch 7, das Folgendes umfasst:

Mischen eines kristallinen Metalloxids mit einem Alkalimetallsalz, das ein Alkalimetallion enthält, zur Bildung einer Mischung, wobei das Metalloxid mindestens ein Übergangsmetallion und mindestens ein Erdalkalimetallion umfasst und das Atomverhältnis zwischen dem Alkalimetallion und dem mindestens einen Erdalkalimetallion höher als 1:1 ist; und
Sintern der Mischung bei einer erhöhten Temperatur zur Bildung einer kristallinen Verbindung, die das Alkalimetallion enthält.

10. Verfahren nach Anspruch 9, wobei es sich bei dem kristallinen Metalloxid um $Bi_2Sr_2CaCu_2O_y$ handelt.

11. Verfahren nach Anspruch 9, wobei 50 % bis 95 % des mindestens einen Erdalkalimetallions durch das Alkalimetallion ersetzt werden.

12. Verfahren nach Anspruch 9, wobei das Atomverhältnis zwischen dem Alkalimetallion und dem mindestens einen Erdalkalimetallion mindestens 2:1 beträgt.

13. Zusammensetzung, umfassend die Verbindung nach Anspruch 1.

14. Verbindung nach Anspruch 1, wobei es sich bei der Verbindung um $Bi_2Rb_2Sr_2CaCu_2O_y$ handelt.

**Revendications**

1.  Composé de formule (I) :

$$L_nD_m(B_xB'_{1-x})_r(Z_tZ'_{1-t})_qM_pA_y \qquad (I),$$

dans lequel

n est un nombre de 0 à 3 ;
m est un nombre de 0 à 6 ;
x est un nombre de 0,4 à 1 ;
r est un nombre de 1 à 8 ;
t est un nombre de 0 à 1 ;
q est un nombre de 0 à 6 ;
p est un nombre de 1 à 7 ;
y est un nombre de 1 à 20 ;
L comprend Bi, Cu ou Hg ;
D comprend au moins un élément choisi dans le groupe constitué par les éléments des groupes IIIA et IVA du tableau périodique ;
B comprend au moins un premier ion de métal alcalin choisi dans le groupe constitué par Na, K, Rb et Cs ;
B' comprend au moins un premier ion choisi dans le groupe constitué par les ions de métaux alcalinoterreux et les ions de métaux des terres rares ;
Z comprend au moins un second ion de métal alcalin choisi dans le groupe constitué par Na, K, Rb et Cs ;
Z' comprend au moins un second ion choisi dans le groupe constitué par les ions de métaux alcalinoterreux et les ions de métaux des terres rares ;
M comprend au moins un ion de métal de transition ; et
A est O ;

le composé étant un composé cristallin.

2.  Composé selon la revendication 1, dans lequel D comprend C, Si, Ge, Sn, Pb ou Al.

3.  Composé selon la revendication 1, dans lequel B' comprend La, Mg, Ca, Sr ou Ba.

4.  Composé selon la revendication 1, dans lequel Z' comprend Ca ou Y.

5.  Composé selon la revendication 1, dans lequel M comprend Cu ou Fe.

6.  Composé selon la revendication 1, le composé ayant une structure cristalline quadratique ou orthorhombique.

7.  Composé, le composé étant un oxyde métallique cristallin comprenant au moins un ion de métal de transition comprenant Bi, Cu ou Hg et au moins un ion de métal alcalinoterreux ou au moins un ion de métal des terres rares, dans lequel de 50 % à 95 % de l'au moins un ion de métal alcalinoterreux ou de l'au moins un ion de métal des terres rares est remplacé par un ion de métal alcalin comprenant Na, K, Rb ou Cs.

8.  Composé selon la revendication 7, dans lequel l'oxyde métallique cristallin avant que de 50 % à 95 % de l'au moins un ion de métal alcalinoterreux ou de l'au moins un ion de métal des terres rares soit remplacé par un ion de métal alcalin comprenant Na, K, Rb ou Cs est $Bi_2Sr_2CaCu_2O_y$.

9.  Procédé pour produire un composé selon la revendication 1 ou selon la revendication 7, comprenant :

le mélange d'un oxyde métallique cristallin avec un sel de métal alcalin contenant un ion de métal alcalin pour former un mélange, dans lequel l'oxyde métallique comprend au moins un ion de métal de transition et au moins un ion de métal alcalinoterreux et le rapport atomique entre l'ion de métal alcalin et l'au moins un ion de métal alcalinoterreux est supérieur à 1:1 ; et
le frittage du mélange à une température élevée pour former un composé cristallin contenant l'ion de métal alcalin.

10. Procédé selon la revendication 9, dans lequel l'oxyde métallique cristallin est $Bi_2Sr_2CaCu_2O_y$.

11. Procédé selon la revendication 9, dans lequel de 50 % à 95 % de l'au moins un ion de métal alcalinoterreux est remplacé par l'ion de métal alcalin.

12. Procédé selon la revendication 9, dans lequel le rapport atomique entre l'ion de métal alcalin et l'au moins un ion de métal alcalinoterreux est d'au moins 2:1.

13. Composition, comprenant le composé selon la revendication 1.

14. Composé selon la revendication 1, le composé étant $Bi_2Rb_2Sr_2CaCu_2O_y$.

FIG. 1

1D metal/superconductor

$E_F$ ———— n-type conductor

$E_F$ ———— superconductor

$E_F$ ———— insulator

$E_F$ ———— superconductor

$E_F$ ———— p-type conductor

FIG. 2A

Fermi
surface

Simple 2D metal

Fermi
volume

2D superconductor

FIG. 2B

EP 3 213 356 B1

Measured Fermi
Landscape

Predicted Fermi
Landscape

FIG. 2C

FIG. 3A

FIG. 3B

EP 3 213 356 B1

FIG. 3C

FIG. 4A

LBCO

YBCO

Legend:
- ○ $Cu^{2+}$, $Cu^{3+}$
- ● $O^{2-}$
- ○ $Y^{3+}$
- ● $Ba^{2+}$

11.6802 Å
3.8872 Å
3.8227 Å

| Ionic Charge (1) | Ionic Radius (1) | Ionic Charge (2) | Ionic Radius (2) | material | No of layers | Tc [K] |
|---|---|---|---|---|---|---|
| +3 (La) | 1.25 | N/A | N/A | LBCO | 1 | 35 |
| +2 (Ba) | 1.98 | N/A | N/A | Hg1201 | 1 | 90 |
| +2 (Sr) | 1.91 | +2 (Ca) | 1.74 | Bi2212 | 2 | 80 |
| +2 (Ba) | 1.98 | +3 (Y) | 1.62 | YBCO | 2 | 92 |
| +2 (Ba) | 1.98 | +2 (Ca) | 1.74 | Tl2212 | 2 | 110 |
| +2 (Ba) | 1.98 | +2 (Ca) | 1.74 | Hg2212 | 2 | 125 |
| +2 (Sr) | 1.91 | +2 (Ca) | 1.74 | Bi2223 | 3 | 110 |
| +2 (Ba) | 1.98 | +2 (Ca) | 1.74 | Tl2223 | 3 | 121 |
| +2 (Ba) | 1.98 | +2 (Ca) | 1.74 | Hg1223 | 3 | 134 |
| +2 (Sr) | 1.91 | N/A | N/A | Bi2201 | 1 | 12 |

FIG. 4B

FIG. 5

FIG. 6

FIG. 7A

FIG. 7B

| Elem | Wt % | At % | K-Ratio | Z | A | F |
|---|---|---|---|---|---|---|
| C K | 4.67 | 22.96 | 0.0094 | 1.2588 | 0.1603 | 1.0001 |
| O K | 8.46 | 31.25 | 0.0167 | 1.2365 | 0.1598 | 1.0002 |
| SrL | 15.62 | 10.54 | 0.1126 | 0.9676 | 0.7446 | 1.0005 |
| K K | 2.55 | 3.85 | 0.0181 | 1.1465 | 0.6192 | 1.0028 |
| CaK | 4.07 | 6.00 | 0.0330 | 1.1680 | 0.6927 | 1.0009 |
| CuK | 11.00 | 10.24 | 0.1157 | 1.0686 | 0.9594 | 1.0259 |
| BiL | 53.64 | 15.17 | 0.4465 | 0.8193 | 1.0071 | 1.0089 |
| Total | 100.00 | 100.00 | | | | |

# FIG. 8

Standard:
O   SiO2   1-Jun-1999 12:00 AM
K   MAD-10 Feldspar   1-Jun-1999 12:00 AM
Ca  Wollastonite   1-Jun-1999 12:00 AM
Cu  Cu   1-Jun-1999 12:00 AM
Sr  SrF2   1-Jun-1999 12:00 AM
Bi  Bi 1-Jun-1999 12:00 AM

| Element | App Conc. | Intensity Comm. | Weight% | Weight% Sigma | Atomic% |
|---------|-----------|-----------------|---------|---------------|---------|
| O K     | 6.88      | 0.7927          | 15.71   | 0.21          | 50.78   |
| K K     | 5.81      | 1.0754          | 9.77    | 0.10          | 12.92   |
| Ca K    | 1.81      | 1.0479          | 3.13    | 0.07          | 4.04    |
| Cu K    | 10.08     | 1.0275          | 17.74   | 0.29          | 14.44   |
| Sr L    | 6..32     | 0.8635          | 13.24   | 0.16          | 7.81    |
| Bi M    | 17.72     | 0.7936          | 40.41   | 0.29          | 10.00   |
| Totals  |           |                 | 100.00  |               |         |

FIG. 9

| HV | curr | WD | mode | det | mag ☐ | ——————— 100 μm ——————— |
|----|------|----|------|-----|-------|--------------------------|
| 15.00 kV | 6.4 nA | 4.0 mm | None | vCD | 1 000 x | 1 |

Spectrum processing:
No peaks omitted

Processing option: All elements analyzed (Normalized)
Number of iterations = 3

Standard:
O SiO2 1-Jun-1999 12:00 AM
K MAD-10 Feldspar 1-Jun-1999 12:00 AM
Ca Wollastonite 1-Jun-1999 12:00 AM
Cu Cu 1-Jun-1999 12:00 AM
Sr SrF2 1-Jun-1999 12:00 AM
Bi Bi 1-Jun-1999 12:00 AM

| Element | App Conc. | Intensity Comm. | Weight% | Weight% Sigma | Atomic% |
|---------|-----------|-----------------|---------|---------------|---------|
| O K | 11.87 | 0.8254 | 15.42 | 0.16 | 55.34 |
| K K | 1.41 | 1.0623 | 1.42 | 0.05 | 2.08 |
| Ca K | 4.57 | 1.0699 | 4.58 | 0.06 | 6.57 |
| Cu K | 13.63 | 1.0673 | 13.68 | 0.20 | 12.37 |
| Sr L | 12.7 | 0.8929 | 15.24 | 0.13 | 9.99 |
| Bi M | 37.33 | 0.8056 | 49.66 | 0.22 | 13.65 |
| | | | | | |
| Totals | | | 100.00 | | |

FIG. 10

FIG. 11

FIG. 12

## FIG. 13

| Elem | Wt % | At % | K-Ratio | Z | A | F |
|------|------|------|---------|---|---|---|
| C K | 2.48 | 13.21 | 0.0055 | 1.3001 | 0.1703 | 1.0001 |
| O K | 8.07 | 32.32 | 0.0218 | 1.2735 | 0.2123 | 1.0003 |
| RbL | 1.94 | 1.46 | 0.0147 | 0.9889 | 0.7635 | 1.0002 |
| SrL | 16.79 | 12.28 | 0.1334 | 0.9872 | 0.8044 | 1.0003 |
| BiM | 48.30 | 14.81 | 0.3886 | 0.8542 | 0.9417 | 1.0001 |
| CaK | 5.60 | 8.96 | 0.0540 | 1.1934 | 0.8075 | 1.0008 |
| CuK | 16.81 | 16.95 | 0.1812 | 1.0960 | 0.9798 | 1.0037 |
| Total | 100.00 | 100.00 | | | | |

FIG. 14

| Elem | Wt % | At % | K-Ratio | Z | A | F |
|------|------|------|---------|------|------|------|
| C K | 3.01 | 21.65 | 0.0056 | 1.3183 | 0.1424 | 1.0001 |
| O K | 2.78 | 15.05 | 0.0056 | 1.2947 | 0.1547 | 1.0002 |
| SrL | 7.42 | 7.32 | 0.0546 | 1.0118 | 0.7276 | 1.0001 |
| CaK | 1.41 | 3.04 | 0.0113 | 1.2260 | 0.6556 | 1.0007 |
| CuK | 9.51 | 12.94 | 0.1054 | 1.1298 | 0.9524 | 1.0306 |
| BiL | 61.54 | 25.47 | 0.5427 | 0.8739 | 1.0053 | 1.0039 |
| RbK | 14.35 | 14.52 | 0.1547 | 1.0854 | 0.9933 | 1.0000 |
| Total | 100.00 | 100.00 | | | | |

## FIG. 15A

FIG. 15B

FIG. 15C

| Elem | Wt % | At % | K-Ratio | Z | A | F |
|------|------|------|---------|---|---|---|
| C K | 2.12 | 13.96 | 0.0037 | 1.2997 | 0.1357 | 1.0001 |
| O K | 4.54 | 22.39 | 0.0093 | 1.2765 | 0.1611 | 1.0003 |
| CaK | 2.75 | 5.42 | 0.0230 | 1.2068 | 0.6905 | 1.0040 |
| CsL | 7.26 | 4.31 | 0.0569 | 0.9441 | 0.8287 | 1.0017 |
| CuK | 10.04 | 12.47 | 0.1081 | 1.1052 | 0.9541 | 1.0215 |
| BiL | 46.96 | 17.73 | 0.4070 | 0.8491 | 1.0056 | 1.0152 |
| SrK | 26.33 | 23.71 | 0.2741 | 1.0538 | 0.9880 | 1.0000 |
| Total | 100.00 | 100.00 | | | | |

# FIG. 16

| Elem  | Wt %   | At %   | K-Ratio | Z      | A      | F      |
|-------|--------|--------|---------|--------|--------|--------|
| C K   | 2.71   | 15.15  | 0.0048  | 1.2781 | 0.1385 | 1.0001 |
| O K   | 7.67   | 32.21  | 0.0155  | 1.2554 | 0.1608 | 1.0003 |
| CaK   | 3.41   | 5.72   | 0.0281  | 1.1861 | 0.6946 | 1.0021 |
| CsL   | 2.85   | 1.44   | 0.0220  | 0.9278 | 0.8301 | 1.0017 |
| CuK   | 9.77   | 10.33  | 0.1039  | 1.0845 | 0.9585 | 1.0232 |
| BiL   | 47.87  | 15.40  | 0.4071  | 0.8314 | 1.0073 | 1.0154 |
| SrK   | 25.73  | 19.74  | 0.2621  | 1.0306 | 0.9885 | 1.0000 |
| Total | 100.00 | 100.00 |         |        |        |        |

FIG. 17

FIG. 18

**X2G50M5D18O7**

FIG. 19

FIG. 20

EP 3 213 356 B1

| Elem | Wt% | At% | K-Ratio | Z | A | F |
|------|------|------|---------|--------|--------|--------|
| C K | 6.34 | 24.87 | 0.0110 | 1.2261 | 0.1421 | 1.0001 |
| O K | 12.77 | 37.62 | 0.0267 | 1.2046 | 0.1734 | 1.0004 |
| CuL | 14.52 | 10.77 | 0.0620 | 1.0054 | 0.4243 | 1.0011 |
| RbI | 16.07 | 8.86 | 0.1107 | 0.9428 | 0.7307 | 1.0002 |
| SrL | 12.17 | 6.55 | 0.0896 | 0.0437 | 0.7801 | 1.0002 |
| BiM | 35.25 | 7.95 | 0.2526 | 0.8201 | 0.8738 | 1.0001 |
| CaK | 2.88 | 3.39 | 0.0243 | 1.1345 | 0.7403 | 1.0013 |
| Total | 100.00 | 100.00 | | | | |

FIG. 21

Electron Image 7

FIG. 22A

FIG. 22B

FIG. 23

FIG. 24

EP 3 213 356 B1

FIG. 25A

FIG. 25B

FIG. 26

FIG. 27

**EP 3 213 356 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 62069212

### Non-patent literature cited in the description

- **BEDNORZ et al.** *Z. Phys. B,* 1986, vol. 64, 189
- **WU et al.** *Phys. Rev. Lett.,* 1987, vol. 58, 908
- **PUTILIN et al.** *Nature,* 1993, vol. 362, 226
- **CHU et al.** *Nature,* 1993, vol. 365, 323
- **KAWAI, T. et al.** *Physica C,* 1989, vol. 161, 561-566
- **SYKOROVA, LD et al.** *Phys. Stat. Sol.,* 2004, vol. 1, 1952-1956
- **NORMAN.** *Phys. Rev. B,* 1995, vol. 52, 615
- **BARDEEN.** *Phys. Rev.,* 1957, vol. 108, 1175
- **BARDEEN et al.** *Phys. Rev.,* 1957, vol. 108, 1175
- **PANAS et al.** *Chem. Phys. Lett,* vol. 259, 247
- **DEUTSCHER et al.** *Chinese Journal of Physics,* 1993, vol. 31, 805
- Low Level Measurements Handbook. Keithley